# EUROPEAN PATENT SPECIFICATION

(11) **EP 3 832 711 B1**
(45) Date of publication and mention of the grant of the patent: **20.12.2023**
(21) Application number: 21151226.4
(22) Date of filing: 14.05.2014
(51) Int. Cl.: H01L 21/8252, H01L 23/498, H01L 25/07, H01L 25/18, H01L 27/06, H01L 27/095, H01L 29/06, H01L 29/10, H01L 29/16, H01L 29/739, H01L 29/78, H02M 7/00, H01L 29/417, H01L 29/66, H01L 23/373, H01L 21/82

(54) **HIGH PERFORMANCE POWER MODULE**
HOCHLEISTUNGSFÄHIGES LEISTUNGSMODUL
MODULE D'ALIMENTATION À HAUTE PERFORMANCE

(30) Priority: 14.05.2013 US 201313893998
(43) Date of publication of application: 09.06.2021
(62) Divisional of application: 14730035.4
(73) Proprietor: Wolfspeed, Inc., Durham, NC 27703 (US)
(72) Inventor: DAS, Mrinal, K., Morrisville, NC 27560 (US); CALLANAN, Robert, J., Raleigh, NC 27612 (US); LIN, Henry, Chapel Hill, NC 27514 (US); PALMOUR, John, Williams, Cary, NC 27511 (US)
(74) Representative: Boult Wade Tennant LLP

(56) References cited:
- EP-A1- 2 432 014
- WO-A1-2012/104969
- WO-A1-2013/036370
- JP-A- 2010 183 840
- US-A1- 2011 069 458
- US-B2- 7 564 129
- HULL B A ET AL: "1700V, 20A 4H-SiC DMOSFETs Optimized for High Temperature Operation", MATERIALS SCIENCE FORUM, TRANS TECH PUBLICATIONS LTD- SWITZERLAND, CH, vol. 679-680, 1 January 2011 (2011-01-01), pages 633-636, XP009518517, ISSN: 0255-5476, DOI: 10.4028/WWW.SCIENTIFIC.NET/MSF.679-680.633

## Description

### FIELD OF THE DISCLOSURE

The present disclosure relates to electronic devices and in particular to power modules.

### BACKGROUND

Power devices made with silicon carbide (SiC) are expected to show great advantages as compared to those on silicon for high speed, high power and/or high temperature applications due to the high critical field and wide band gap of SiC. For devices capable of blocking high voltages, such as voltages in excess of about 5 kV, it may be desirable to have bipolar operation to reduce the drift layer resistance via conductivity modulation resulting from injected minority carriers. However, one technical challenge for bipolar devices in silicon carbide is forward voltage degradation over time, possibly due to the presence of Basal Plane Dislocations (BPD) in single crystals of silicon carbide. Thus, unipolar devices such as SiC Schottky diodes and MOSFETs are typically used for high power applications, e.g., up to 10kV or more.

SiC DMOSFET devices with a 10 kV blocking capability have been fabricated with a specific on-resistance of about 100 mΩ×cm². DMOSFET devices may exhibit very fast switching speeds of, for example, less than 100 ns, due to their majority carrier nature. However, as the desired blocking voltage of devices increases, for example up to 15 kV or more, the on-resistance of a MOSFET device may increase substantially, due to the corresponding increase in the drift layer thickness. This problem may be exacerbated at high temperatures due to bulk mobility reduction, which may result in excessive power dissipation.

With the progress of SiC crystal material growth, several approaches have been developed to mitigate BPD related problems. See, e.g., B. Hull, M. Das, J. Sumakeris, J. Richmond, and S. Krishinaswami, "Drift-Free 10-kV, 20-A 4H-SiC PiN Diodes", Journal of Electrical Materials, Vol. 34, No. 4, 2005. These developments may enhance the development and/or potential applications of SiC bipolar devices such as thyristors, GTOs, etc. Even though thyristors and/or GTOs may offer low forward voltage drops, they may require bulky commutating circuits for the gate drive and protections. Accordingly, it may be desirable for a SiC bipolar device to have gate turn-off capability. Due to their superior on-state characteristics, reasonable switching speed, and/or excellent safe-operation-area (SOA), 4H-SiC insulated gate bipolar transistors (IGBTs) are becoming more suitable for power switching applications.

These devices are used in power modules, which operate to dynamically control large amounts of power through switching for motors, inverters, generators, and the like.
US2011/0069458 discloses power module including a metal base, a ceramic substrate, a semiconductor chip, a nut holder housing a nut, an electrode terminal and a casing. The ceramic substrate is connected to an upper surface of the metal base via a lower electrode. The semiconductor chip is located on a first major surface of the ceramic substrate. The electrode terminal includes a bent portion surrounding a nut holder. The electrode terminal includes a first connecting portion extending perpendicularly to the bent portion from one end of the bent portion, and being located on the first major surface via an upper electrode, and electrically connected to the semiconductor chip. A casing is bonded to the metal base to enclose the semiconductor chip and the electrode terminal. An upper end portion of the bent portion of the electrode terminal is exposed to outside of the casing through the opening.
There remains a continuing need for power modules that are smaller and less expensive to manufacture while at the same time being capable of controlling larger loads.

### SUMMARY

The present disclosure relates to a power module according to claim 1. Embodiments have a housing with an interior chamber and a plurality of switch modules interconnected to facilitate switching power to a load. Each of the plurality of switch modules comprises at least one transistor and at least one diode mounted within the interior chamber and both the at least one transistor and the at least one diode are majority carrier devices, are formed of a wide bandgap material system, or both. The switching modules may be arranged in a six-pack.

In one embodiment, the transistors and diodes are formed from silicon carbide (SiC), the transistors are MOSFETs, and the diodes are Schottky diodes or junction barrier Schottky diodes. The transistors and diodes may be coupled in anti-parallel as well as be provided in arrays to increase power-handling capabilities. The devices of the present disclosure are very efficient and cost effective to manufacture while exceeding the performance currently available state-of-the-art products. For example, a six-pack power module employing SiC MOSFETS and junction barrier Schottky diodes in the switching modules can block 1200 volts, conduct 50 amperes, and have switching losses of well less than ten milli-Joules. As such, switching losses with this power module are around 70% less than currently available state-of-the-art products that have the same blocking and conduction ratings. Further, these devices are able to operate at significantly higher switching frequencies.

### BRIEF DESCRIPTION OF THE DRAWINGS

The accompanying drawings, which are included to provide a further understanding of the disclosure and are incorporated in and constitute a part of this application, illustrate certain embodiment(s) of the disclosure. In the drawings:
Figure 1 is a circuit diagram of an H-bridge for an exemplary power module that is configured to drive a motor.
Figure 2 illustrates a first current path in the H-bridge of Figure 1 when driving the motor in a first direction.
Figure 3 illustrates a second current path in the H-bridge of Figure 1when driving the motor in a second direction.
Figure 4 is a circuit diagram of a switch module of the H-bridge of Figure 1.
Figure 5 is a top plan view of a power module.
Figure 6 is an isometric view of the power module of Figure 5.
Figure 7 is a circuit diagram of a power module according to one embodiment of the present disclosure.
Figure 8 is a top view of a housing for a power module according to one embodiment of the present disclosure.
Figure 9 is a circuit diagram of a three-phase motor drive circuit including a power module.
Figures 10A-10D illustrate generation of a drive current according to one embodiment of the present disclosure.
Figure 11 is a graph comparing switching losses using existing power modules and the power modules of the present disclosure.
Figure 12 is a block diagram of the internal structure of a power module according to one embodiment of the present disclosure.
Figure 13 is a circuit diagram of a metal-oxide-semiconductor field effect (MOSFET) device.
Figure 14 is a graph illustrating hypothetical on-state current-voltage characteristics for a MOSFET device.
Figure 15 is a graph illustrating the effect of source resistance on gate voltage.
Figure 16 is a partial cross sectional illustration of cell of a conventional power MOSFET device.
Figures 17 and 18 are plan views illustrating layouts of conventional power MOSFET devices.
Figures 19 and 20 are plan views illustrating layouts of power MOSFET devices.
Figures 21 and 22 are partial cross sectional illustrations of a cell of a power MOSFET device.
Figure 23 is a graph on-state current-voltage characteristics for a MOSFET device.
Figure 24 is a cross sectional illustration of cell of a power MOSFET device.
Figure 25 is a cross sectional illustration of cell of an insulated gate bipolar transistor device.
Figure 26 is a cross sectional illustration of cell of a p-type insulated gate bipolar transistor device.
Fig. 27 is a graph showing current-voltage characteristics of the P-IGBT device of Figure 26.
Fig. 28A is a graph showing voltage blocking characteristics of the p-IGBT of Figure 26.
Fig. 28B is a graph showing pulsed on-state current-voltage characteristics of the P-IGBT of Figure 26.
Fig. 28C is a graph showing further on-state current-voltage characteristics of the P-IGBTs of Figure 26 for temperatures ranging from room temperature to 300°C.
Fig. 28D is a graph showing on-state current-voltage characteristics of the P-IGBTs of Figure 26 as a function of temperature.

### DETAILED DESCRIPTION OF EMBODIMENTS OF THE DISCLOSURE

Embodiments of the present disclosure now will be described more fully hereinafter with reference to the accompanying drawings, in which embodiments of the disclosure are shown. This disclosure may, however, be embodied in many different forms and should not be construed as limited to the embodiments set forth herein. Rather, these embodiments are provided so that this disclosure will be thorough and complete, and will fully convey the scope of the disclosure to those skilled in the art. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

Embodiments of the disclosure are described herein with reference to cross-section illustrations that are schematic illustrations of idealized embodiments (and intermediate structures) of the disclosure. The thickness of layers and regions in the drawings may be exaggerated for clarity. Additionally, variations from the shapes of the illustrations as a result, for example, of manufacturing techniques and/or tolerances, are to be expected. Thus, embodiments of the disclosure should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a discrete change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the disclosure.

Some embodiments of the disclosure are described with reference to semiconductor layers and/or regions which are characterized as having a conductivity type such as n-type or p-type, which refers to the majority carrier concentration in the layer and/or region. Thus, n-type material has a majority equilibrium concentration of negatively charged electrons, while p-type material has a majority equilibrium concentration of positively charged holes. Some material may be designated with a "+" or "-" (as in n+, n-, p+, p-, n++, n--, p++, p--, or the like), to indicate a relatively larger ("+") or smaller ("-") concentration of majority carriers compared to another layer or region. However, such notation does not imply the existence of a particular concentration of majority or minority carriers in a layer or region.

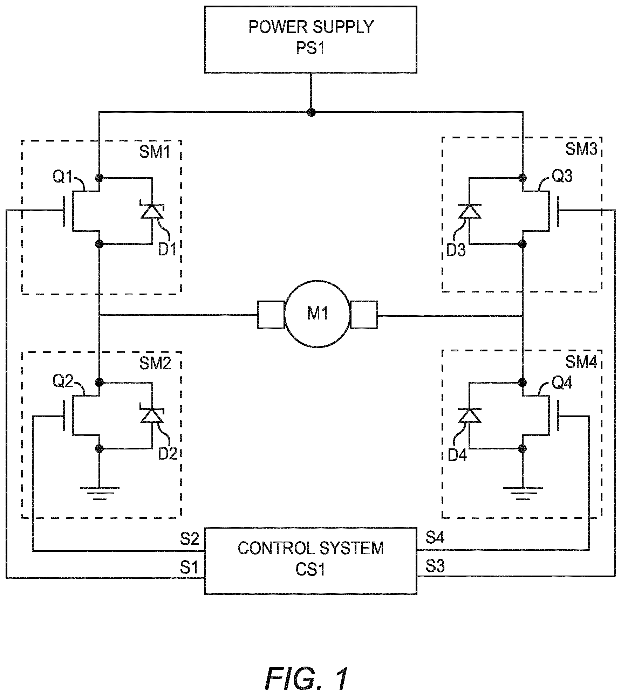

An exemplary system that employs a power module is illustrated in Figure 1. As depicted, the power module can include four switch modules SM1-SM4, which are controlled by a control CS1 to deliver power from a power supply PS 1 to a load in a controlled manner. The switch modules SM1 and SM2 form a first half of an H-bridge, while switch modules SM3 and SM4 form a second half of the H-bridge. As noted, power modules are often used to drive an inductive load, such as that provided by a direct current (DC) motor M1. The details of the switch modules SM1-SM4 are described in further detail below.

For now, assume the switch modules SM1-SM4 can include at least one transistor in parallel with an internal or external diode that is connected in anti-parallel with the transistor. The transistors are illustrated as metal oxide field effect transistors (MOSFETs), and the diodes are illustrated as Schottky diodes for purposes of description. The MOSFETs may be replaced with other types of transistors, such as bipolar transistors, including insulated gate bipolar transistors (IGBTs), and various kinds of field effect transistors (FETs), such as junction field effect transistors (JFETs), and high electron mobility transistors (HEMTs). Similarly, the Schottky diodes may be replaced with traditional p-n diodes.

As illustrated, switch module SM1 may include either an n-channel or p-channel MOSFET Q1 that has a Schottky diode D1 connected in anti-parallel across the drain and source terminals of the MOSFET Q1. Switch modules SM2-SM4 are similarly configured. Switch module SM2 includes an n-channel MOSFET Q2 that has a Schottky diode D2 connected in anti-parallel across the drain and source terminals of the MOSFET Q2. Switch module SM3 may include either an n-channel or p-channel MOSFET Q3 that has a Schottky diode D3 connected in anti-parallel across the drain and source terminals of the MOSFET Q3. Switch module SM4 includes an n-channel MOSFET Q4 that has a Schottky diode D4 connected in anti-parallel across the drain and source terminals of the MOSFET Q4.

The switch modules SM1 and SM3 are considered on the "high" side, and the switch modules SM2 and SM4 are considered on the "low" side of the power module. The drains of MOSFETs Q1 and Q3 and the cathodes of diodes D1 and D3 are coupled together and to the power supply PS1. The source of MOSFET Q1, the anode of diode D1, the drain of MOSFET Q2, and the cathode of diode D2 are coupled together and to a first terminal of the motor M1. The source of MOSFET Q3, the anode of diode D3, the drain of MOSFET Q4, and the cathode of diode D4 are coupled together and to a second terminal of the motor M1. Finally, the sources of MOSFETs Q2 and Q4 and the anodes of diodes D2 and D4 are coupled to ground. The gates of MOSFETs Q1-Q4 are respectively driven by control signals S1-S4, which are provided by the control system CS1. Assume the motor M1 may be driven in both forward and reverse directions.

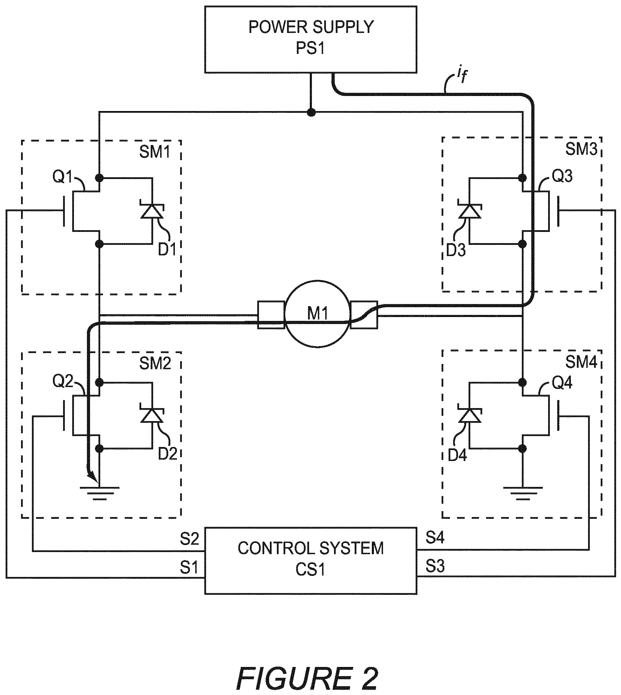

For forward operation, assume control signals S1-S4 are configured to turn on MOSFETs Q2 and Q3 and turn off MOSFETs Q1 and Q4, which corresponds to driving the motor M1 in a forward direction. As illustrated in Figure 2, a forward current *i_{f}* flows from the power supply PS1 through MOSFET Q3, the motor M1, and the MOSFET Q2 to ground. If MOSFETs Q2 and Q3 stay on, the maximum forward current *i_{f}* is provided and the motor M1 will turn in the forward direction at a maximum speed, with maximum torque, or a combination thereof.

To control the speed or torque, one or both of the MOSFETs Q2 and Q3 may be switched off and on at a duty cycle that corresponds to the speed or torque desired from the motor M1. As a result, the voltage supplied to the motor M1 is pulse width modulated, wherein the on-to-off switching ratio of the MOSFETs Q2 and Q3 dictates the average voltage presented to the Motor M1. The inductive nature of the motor M1 tries to keep the forward current *i_{f}* constant, and as a result, averages the voltage presented to the motor M1 to a level corresponding to the on-to-off switching ratio of the MOSFETs Q2 AND Q3. The average voltage presented to the motor M1 dictates the forward current *i_{f}* that is passed through the motor M1, and thus, controls the actual speed or torque of the motor M1.

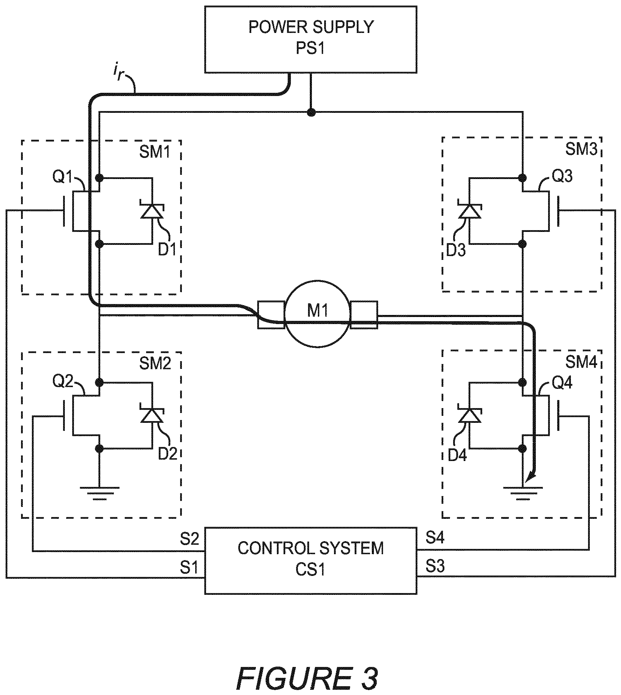

For reverse operation, assume control signals S1-S4 are configured to turn on MOSFETs Q1 and Q4 and turn off MOSFETs Q2 and Q3. As illustrated in Figure 3, a reverse current *iᵣ* flows from the power supply PS1 through MOSFET Q1, the motor M1, and the MOSFET Q4 to ground. If MOSFETs Q1 and Q4 stay on, the maximum reverse current *iᵣ* is provided and the motor M1 will turn in the reverse direction at a maximum speed, with maximum torque, or a combination thereof. Notably, the term "reverse" when used as an adjective in the term "reverse current *iᵣ,"* merely refers to the direction of operation for the motor M1. The arrows provided in Figures 2 and 3, respectively, indicate the direction of current flow for both the forward current *i_{f}* and the reverse current *iᵣ.*

As described above, the various MOSFETs Q1-Q4 may be turned on and off at a relatively high frequency to provide pulse width modulated voltage to the motor M1 for either forward or reverse operation as well as to switch from forward operation to reverse operation. When a pair of MOSFETs, such as MOSFETs Q2 and Q3 transition from an on-state to an off-state during forward operation, the forward current *i_{f}* continues to flow through the motor M1 after the MOSFETs Q2 and Q3 are turned off, due to the electromagnetic field that is present in the inductive windings of the motor M1. At this point, all of the MOSFETs Q1-Q4 are off, yet the forward current *i_{f}* remains flowing through the motor M1. Since the forward current *i_{f}* cannot flow through any of the MOSFETS Q1-Q4 to a lower potential node, one or more of the Schottky diodes D1 though D4 may become forward biased and provide a path for the forward current *i_{f}* to flow to either ground or the power supply PS1.

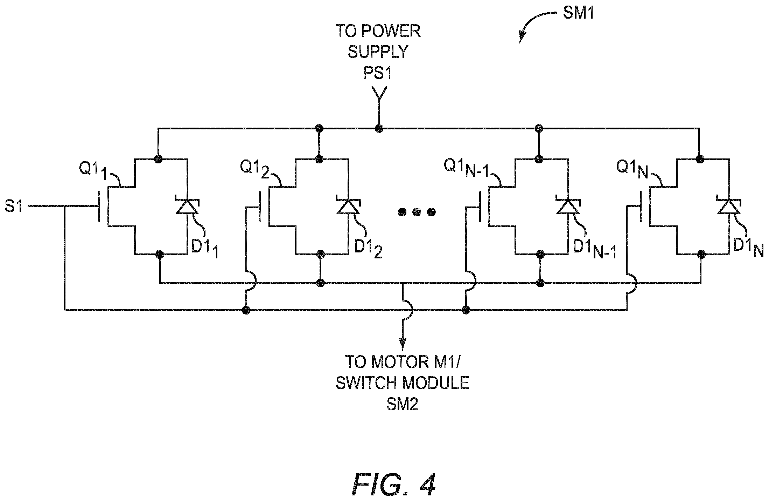

To increase the power handling of a switch module SM1-SM4, each of the MOSFETs Q1-Q4 may represent an array of effectively parallel transistors. Similarly, each of the Schottky diodes D1-D4 may represent an array of effectively parallel diodes. This concept is represented in Figure 4. The other switch modules SM2-SM3 may be similarly configured.

As illustrated, switch module SM1 includes an array of MOSFETs Q1₁ - Q1_{N}, which are effectively coupled in parallel, such that the drains are all coupled together and to the power supply PS1; the sources are all coupled together and to the motor M1 and switch module SM2; and the gates are coupled together and to the control system C1 (control signal S1). The Schottky diodes D1₁ - D1_{N} are coupled in anti-parallel across the drain and sources of the MOSFETs Q1₁ - Q1_{N}. The number (N) of MOSFETs Q1₁ - Q1_{N} and Schottky diodes D1₁ - D1_{N} may range from two to more than 100, depending on the capability of each individual device and the application. Notably, there may be two or more Schottky diodes D1 for each MOSFET Q1, even though there is only a one-to-one relationship in the illustration.

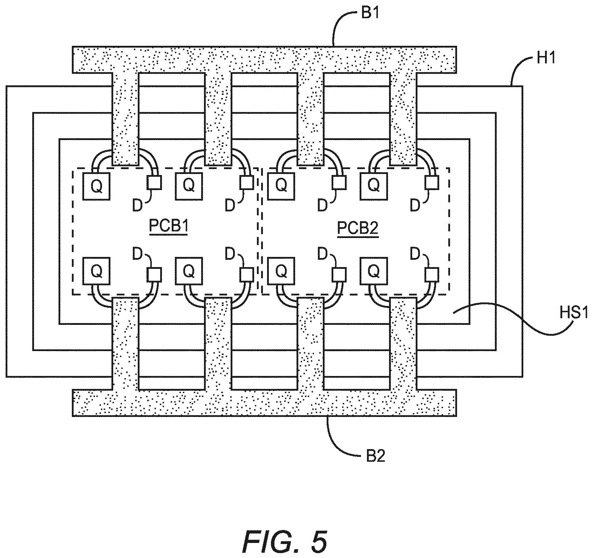

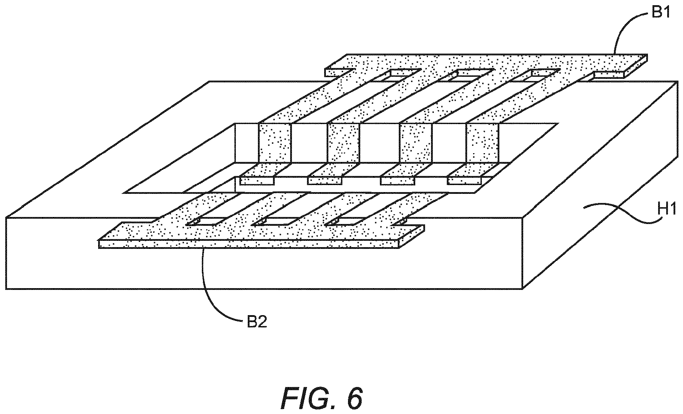

Figures 5 and 6 show top and perspective views of an exemplary power module. With reference to Figure 5, rectangular housing H1 is provided with an interior chamber that holds one or more printed circuit boards PCB 1 and PCB2. For clarity, the printed circuit boards PCB 1 and PCB2 are not shown in Figure 6. Each printed circuit board PCB1 and PCB2 is shown as having multiple transistors Q and diodes D that represent the primary components of the switch modules SW1-SW4. For example, the high and low side of the first half-H bridge formed by switch modules SW1 and SW2 are provided on printed circuit board PCB 1, while the high and low side of the second half-H bridge formed by switch modules SW3 and SW4 are provided on printed circuit board PCB2. Together, the first and second half-H bridges form the above-described full-H bridge.

The necessary interconnects between the components on the printed circuit boards PCB1 and PCB2 are provided by metal traces (not shown) on the printed circuit boards PCB 1 and PCB2. Bond wires may be used to make connections between the printed circuit boards PCB 1 and PCB2 and one more connectors or buses B 1 and B2. For example, bus B 1 may be used to connect switch modules SM2 and SM4 to ground, and bus B2 may be used to connect switch modules SM1 and SM3 to the power supply PS1. These or other connectors may be used for the control signals S1-S4. The printed circuit boards PCB1 and PCB2 may be mounted to a mounting structure that is affixed to the housing H1. As illustrated, the mounting structure is a planar heat sink HS1 that also functions to dissipate heat generated by the switch modules SM1-SM4.

Again, the H-bridge configuration of the power module is just one of many available designs for power modules, especially those used to drive inductive loads. Alternatives to the H-bridge configuration for the power module include a half-H bridge and like known power switching or control circuits.

Regardless of the type of configuration of the power module, one metric for measuring the power handling capabilities of the device is current density of one of the switch modules SM1-SM4. This switch module current density is defined as the ratio of the maximum average current that a single switch module SM1-SM4 can handle to the interior area of the housing H1 that is allocated to the single switch module SM1-SM4. For the illustrated example, there are four switch modules SM1-SM4 of equal size. As such, the interior area of the housing H1 that is allocated to a single switch module SM1-SM4 is one-fourth (1/4) the total interior area of the housing H1.

For example, assume the interior area of the housing H1 is 100 cm², and the maximum average current handling of one of the switch modules SM1-SM4 is 250 amperes. As such, the interior area of the housing H1 that is allocated to a single switch module SM1-SM4 is one-fourth of 100 cm², or 25 cm². The switch module current density is calculated by dividing the maximum average current handling of 250 amperes by the interior area of the housing H1 that is allocated to the single switch module SM1-SM4, which yields 10 amperes/cm².

The interior area of the housing H1 is defined as the maximum (two-dimensional) cross-sectional area of the interior of the housing H1 wherein the plane of measurement is along the plane in which one or more printed circuit boards PCB 1 and PCB2 or one or more semiconductor die that provide the switch modules SM1-SM4 reside. For the illustrated example in Figure 5, the interior area is defined by the perimeter P of the inside wall of the housing H1. The perimeter P is highlighted in bold. Notably, since the housing H1 may have various shapes and configurations in addition to the rectangular configuration shown in Figures 5 and 6, the interior areas need not be rectangular and the perimeter of the interior areas will follow the interior sidewalls of the housing H1. In one example, the switch module current density is about 10 amperes/cm²or greater. In another example, the switch module current density is about 12 amperes/cm² or greater. In another example, the switch module current density is about 15 amperes/cm² or greater.

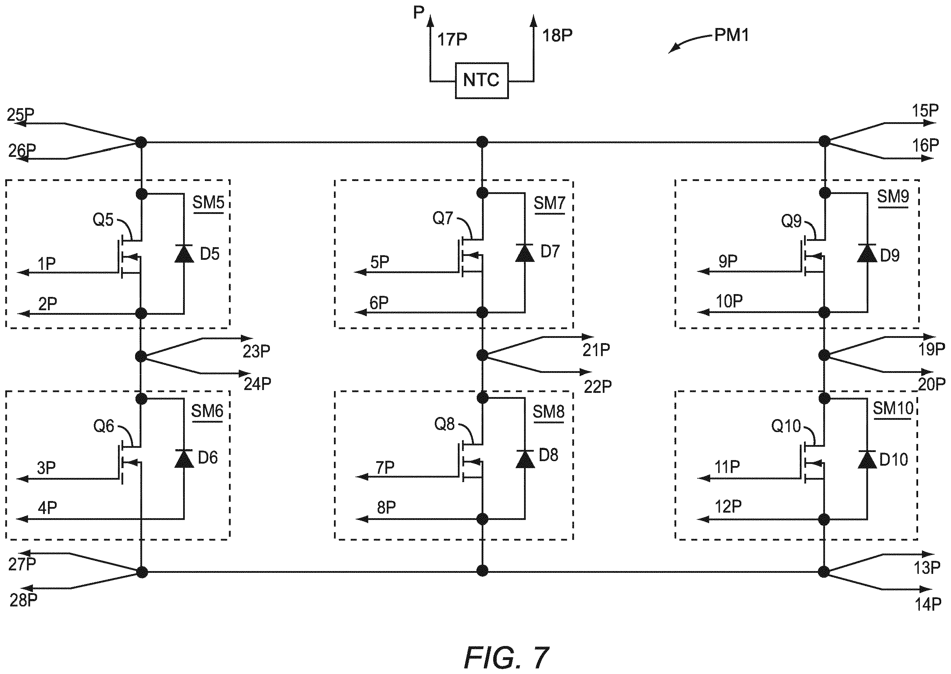

Another exemplary power module PM1 is illustrated in Figure 7. As depicted, the power module PM1 includes six switch modules SM5-SM10, which are distributed among three shunt legs. The power module PM1 is particularly useful in three-phase applications, such as three-phase inverters, three-phase motor drivers, uninterruptable power supplies, and the like. The switch modules SM5 and SM6 are series connected and form a first shunt leg of the power module PM1, the switch modules SM7 and SM8 are series connected and form a second shunt leg of the power module PM1, and the switch modules SM9 and SM10 are series connected and form a third shunt leg of the power module PM1. The details of the switch modules SM5-SM10 are described in further detail below.

The transistors are illustrated as SiC MOSFETs, and the diodes are illustrated as SiC Schottky diodes for purposes of description. However, the MOSFETs may be replaced with other types of transistors, such as bipolar transistors, including insulated gate bipolar transistors (IGBTs), and various kinds of field effect transistors (FETs), such as junction field effect transistors (JFETs), and high electron mobility transistors (HEMTs). In certain embodiments, the Schottky diodes may be replaced with traditional p-n diodes.

For the first shunt leg of the power module PM1, switch module SM5 may include either an n-channel or p-channel MOSFET Q5 that has a Schottky diode D5 connected in anti-parallel across the drain and source terminals of the MOSFET Q5. Switch modules SM6-SM10 are similarly configured. Switch module SM6 includes an n-channel MOSFET Q6 that has a Schottky diode D6 connected in anti-parallel across the drain and source terminals of the MOSFET Q6. For the second shunt leg, switch module SM7 may include either an n-channel or p-channel MOSFET Q7 that has a Schottky diode D7 connected in anti-parallel across the drain and source terminals of the MOSFET Q7. Switch module SM8 includes an n-channel MOSFET Q8 that has a Schottky diode D8 connected in anti-parallel across the drain and source terminals of the MOSFET Q8. For the third shunt leg, switch module SM9 may include either an n-channel or p-channel MOSFET Q9 that has a Schottky diode D9 connected in anti-parallel across the drain and source terminals of the MOSFET Q9. Switch module SM10 includes an n-channel MOSFET Q10 that has a Schottky diode D10 connected in anti-parallel across the drain and source terminals of the MOSFET Q10.

The switch modules SM5, SM7, and SM9 are considered on the "high" side, and the switch modules SM6, SM8, and SM10 are considered on the "low" side of the power module. The drains of MOSFETs Q5, Q7, and Q9 and the cathodes of diodes D5, D7, and D9 are coupled together and to pins 15P, 16P, 25P, and 26P. The sources of MOSFETs Q6, Q8, and Q10 and the anodes of diodes D6, D8, and D10 are coupled to ground and to pins 13P, 14P, 27P, and 28P. Multiple pins are used for certain nodes to help increase current handling capabilities of the power module PM1. To increase the power handling of a switch module SM5-SM10, each of the MOSFETs Q6-Q10 may represent an array of effectively parallel transistors. Similarly, each of the Schottky diodes D5-D10 may represent an array of effectively parallel diodes. This concept is represented in Figure 4. The switch modules SM5-SM10 may be similarly configured.

For the first shunt leg, the source of MOSFET Q5, the anode of diode D5, the drain of MOSFET Q6, and the cathode of diode D6 are coupled together and to pins 2P, 23P, and 24P. For the second shunt leg, the source of MOSFET Q7, the anode of diode D7, the drain of MOSFET Q8, and the cathode of diode D8 are coupled together and to pins 6P, 21P, and 22P. For the third shunt leg, the source of MOSFET Q9, the anode of diode D9, the drain of MOSFET Q10, and the cathode of diode D10 are coupled together and to pins 10P, 19P, and 20P. The gates of the high-side MOSFETs Q5, Q7, and Q9 are coupled to pins 1P, 5P, and 9P, respectively. The gates of the low-side MOSFETs Q6, Q8, and Q10 are coupled to pins 3P, 7P, and 11P.

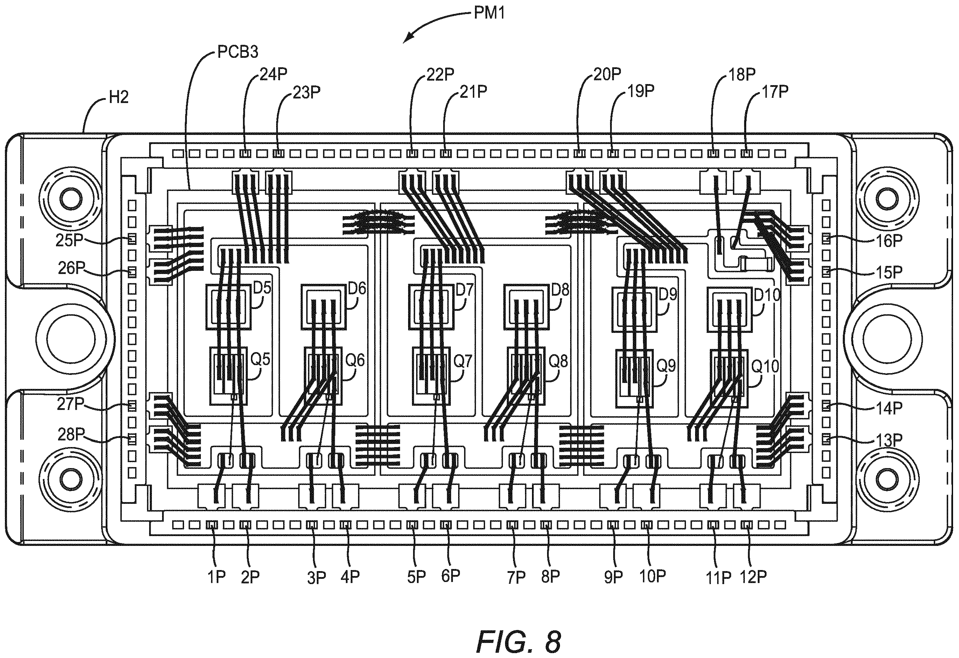

Figure 8 shows a top view of an exemplary housing H2 for power module PM1. The elongated and substantially rectangular housing H2 is provided with an interior chamber that holds one or more printed circuit boards PCB3. Printed circuit board PCB3 is shown as having multiple transistors Q5-Q10 and diodes D5-D10 that represent the primary components of the switch modules SM5-SM10. The thicker, dark lines represent wirebonds between components and between components and the various pins 1P-28P. Other interconnects between the components on the printed circuit board PCB3 are provided by metal traces. As illustrated, the mounting structure may form all or part of a heat sink that functions to dissipate heat generated by the switch modules SM5-SM10.

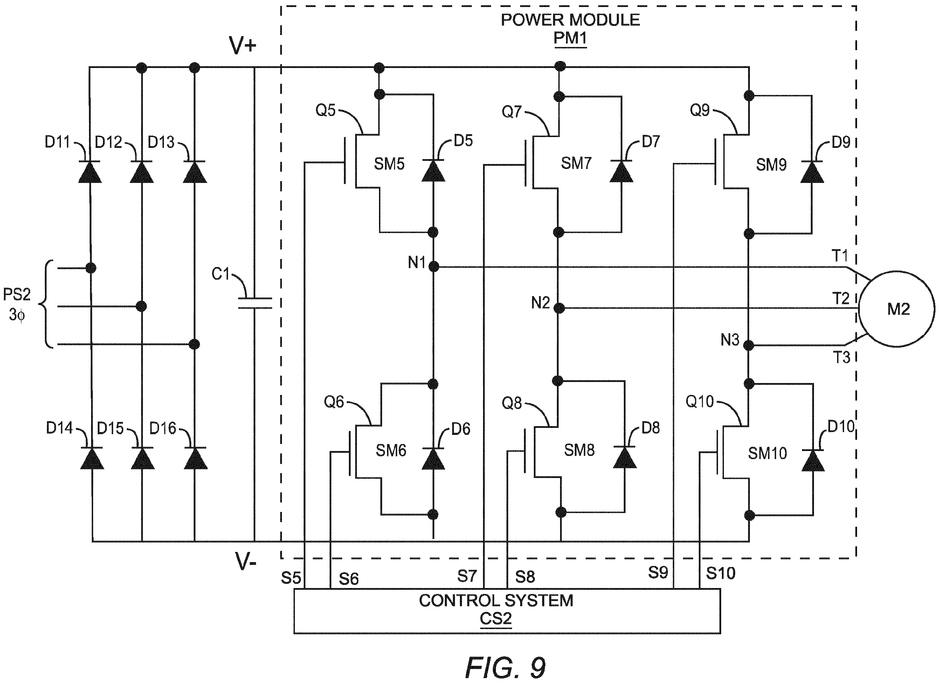

With reference to Figure 9, power module PM1 is shown as part of a three-phase motor drive circuit that is coupled between a three-phase power supply PS3 and a three-phase motor M2. The three-phase motor M2 has three input terminals T1, T2, and T3. A control system CS2 is used to control generation and delivery of three drive currents to the respective input terminals T1, T2, and T3 by modulating the gates of MOSFETs Q5-Q10 of the switch modules SM5-SM10 with control signals S5-S10. The drive currents will be 120 degrees out-of-phase with one another and are varied in frequency to control speed and direction of the motor M2. Generation of the drive signals and operation of the three-phase motor drive circuit is described below.

Power supply PS2 provides three sinusoidal AC signals, which are 120 degrees out-of-phase from one another, to rectifier circuitry that is represented by diodes D11-D16 and capacitor C1. The rectifier circuitry effectively rectifies the three-phase signal and provides a rectified positive rail voltage V+ to a first bus and a rectified negative voltage V- to a second bus. The positive rail voltage V+ is provided to the drains of MOSFETs Q5, Q7, and Q9 and the cathodes of diodes D5, D7, and D9 of switch modules SM5, SM7, and SM9 via the first bus and the negative rail voltage V- is provided to the sources of MOSFETs Q6, Q8, and Q10 and anodes of diodes D6, D8, and D10 of switch modules SM6, SM8, and SM10 via the second bus.

For the first drive current, a first drive signal for terminal T1 is generated at a first node N1, which resides in the first shunt leg and between the switch module SM5 and the switch module SM6. The first drive signal is controlled by control signals S5 and S6. For the second drive current, a second drive signal for terminal T2 is generated at a second node N2, which resides in the second shunt leg and between the switch module SM7 and the switch module SM8. The second drive signal is controlled by control signals S7 and S8. For the third drive current, a third drive signal for terminal T3 is generated at a third node N3, which resides in the third shunt leg and between the switch module SM9 and the switch module SM10. The third drive signal is controlled by control signals S9 and S10.

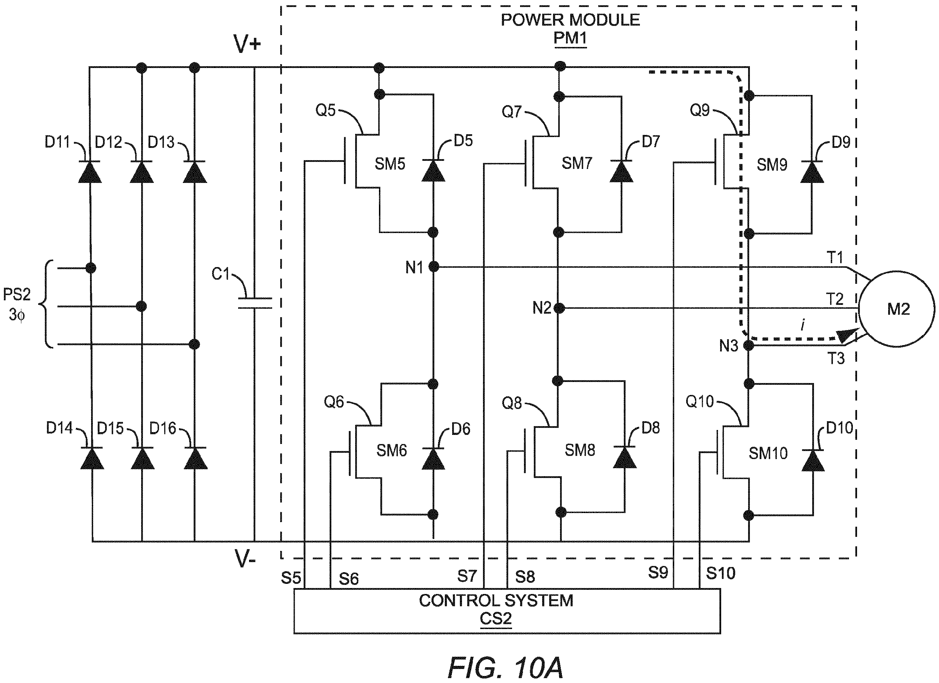

Generation of the third drive current using the third drive signal is described in detail in association with Figures 10A through 10D. Notably, each drive signal is effectively a pulse width modulated signal that is filtered by the internal or external inductance associated with the motor M2 to provide a sinusoidal drive current having a desired frequency and amplitude. To generate the positive half-cycle of the sinusoidal drive current, control signal S9 provides a pulse width modulated signal to the gate of MOSFET Q9 throughout the positive half-cycle, and a control signal S10 is provided to the gate of the MOSFET Q10 to bias MOSFET Q10 off. Providing the pulse width modulated signal to the gate of MOSFET Q9 effectively generates a pulse width modulated signal at node N3 that switches between the positive rail voltage V+ and the negative rail voltage V-. In general, MOSFET Q9 is turned on when the pulse width modulated signal at node N3 is positive and turned off when the pulse width modulated signal at N3 is negative.

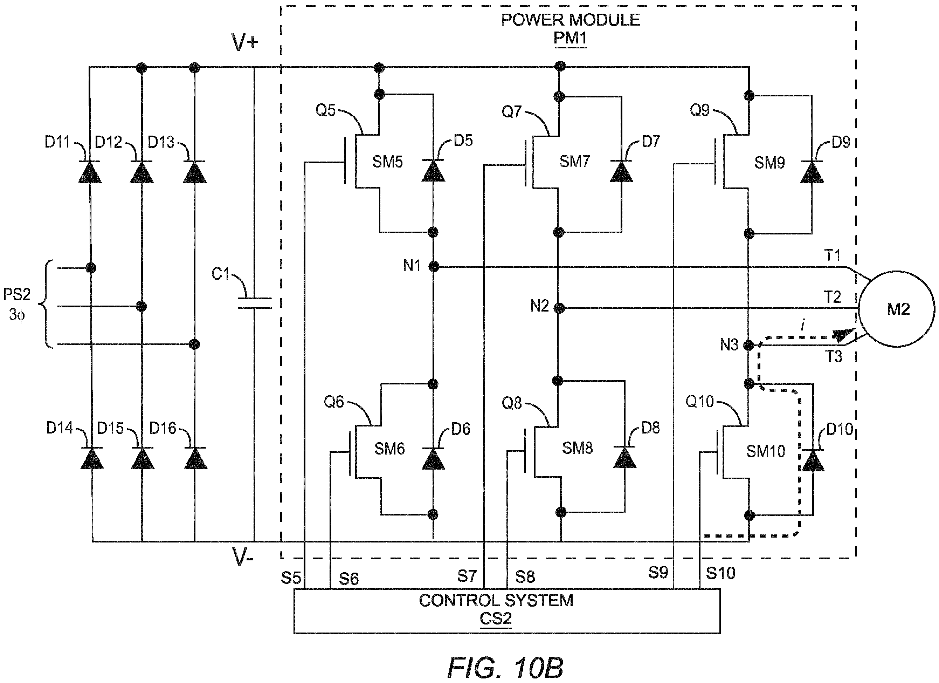

As shown in Figure 10A, when the pulse width modulated signal at node N3 is positive, drive current i will flow through MOSFET Q9 of switch module SM9 and to terminal T3 of motor M2 through the inductance associated with the motor M2. The inductance associate with the motor M2 will tend to force the drive current i to continue to flow into terminal T3 even as the pulse width module signal at node N3 goes negative and MOSFET Q9 is turned off. As illustrated in Figure 10B, the drive current i switches from flowing through MOSFET Q9 of switch module SM9 to flowing through a now forward biased diode D10 of switch module SM10 to terminal T3 of the motor M2. When the pulse width modulated signal at node N3 goes positive again, MOSFET Q9 will be turned back on and the drive current i will switch back to flowing through MOSFET Q9 of switch module SM9 and to terminal T3 of motor M2, as provided in Figure 10A. This process will continue for several cycles throughout the positive half-cycle of the drive current i. The period or duty cycle of the pulse width modulated control signal S9 is varied throughout the positive half-cycle to provide the sinusoidal nature of the drive current i.

To generate the negative half-cycle of the sinusoidal drive current, control signal S10 provides a pulse width modulated signal to the gate of MOSFET Q10 throughout the negative half-cycle, and a control signal S9 is provided to the gate of the MOSFET Q9 to bias MOSFET Q9 off. Providing the pulse width modulated signal to the gate of MOSFET Q10 effectively generates a pulse width modulated signal at node N3 that switches between the positive rail voltage V+ and the negative rail voltage V-. In general, MOSFET Q10 is turned on when the pulse width modulated signal at node N3 is negative and turned off when the pulse width modulated signal at N3 is positive.

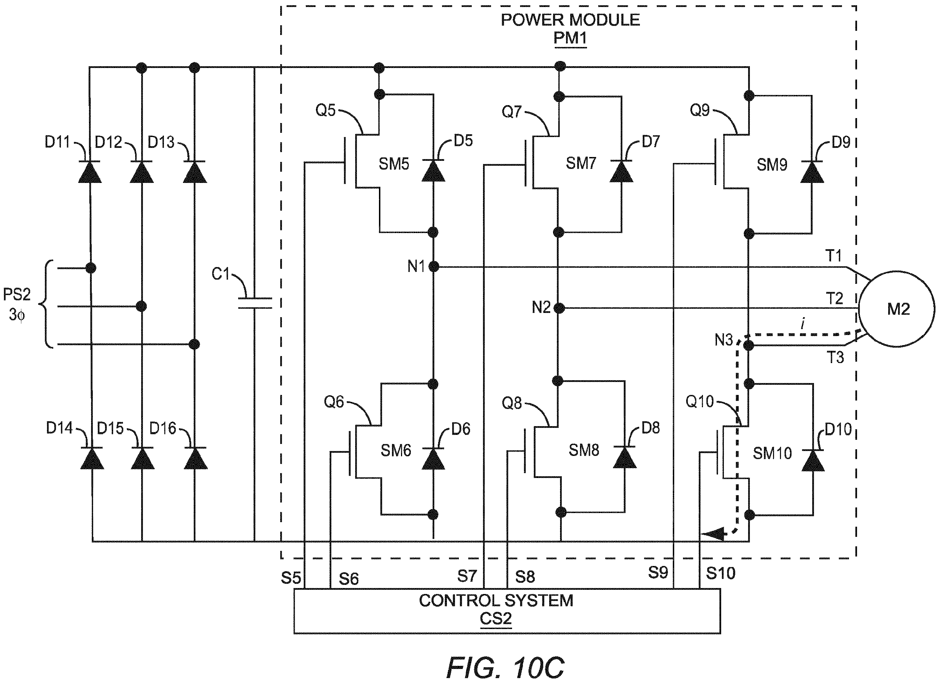

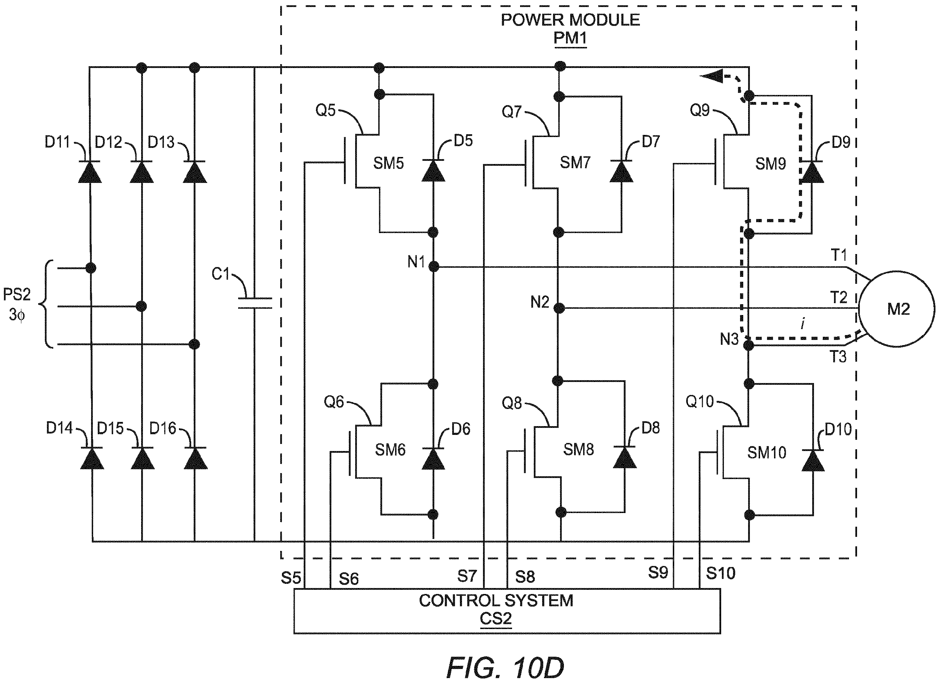

As shown in Figure 10C, when the pulse width modulated signal at node N3 is negative, drive current i will flow through MOSFET Q10 of switch module SM10 from terminal T3 of motor M2 through the inductance associated with the motor M2. The inductance associate with the motor M2 will tend to force the drive current i to continue to flow from terminal T3 even as the pulse width module signal at node N3 goes positive and MOSFET Q10 is turned off. As illustrated in Figure 10D, the drive current i switches from flowing through MOSFET Q10 of switch module SM10 to flowing through a now forward biased diode D9 of switch module SM9 from terminal T3 of the motor M2. When the pulse width modulated signal at node N3 goes negative again, MOSFET Q10 will be turned back on and the drive current i will switch back to flowing through MOSFET Q10 of switch module SM10 from terminal T3 of motor M2, as provided in Figure 10C. This process will continue for several cycles throughout the negative half-cycle of the drive current i. The period or duty cycle of the pulse width modulated control signal S10 is varied throughout the positive half-cycle to provide the sinusoidal nature of the drive current i.

Modules configured like the power module PM1 of Figure 7 are often referred to as "six-pack" modules because there are six switches in the overall power module. The current state-of-the-art for six-pack modules employs silicon (Si)-based IGBTs and PiN diodes, which are both minority carrier devices. Applicants believe the use of minority carrier or Si-based devices significantly limit both the performance and overall cost effectiveness of these six-pack modules for a variety of reasons. Further, applicants have discovered that the use of majority carrier devices that are fabricated from a wide bandgap material system, such as SiC, offer tremendous performance increases over the state-of-the-art six-pack modules.

Six-pack modules that use Si-based, minority carrier transistors and diodes are limited in switching (or operating) frequency, have high switching and overall power losses, generally require soft switching, and suffer from second breakdown at higher operating currents. However, a six-pack module that uses majority carrier transistors and diodes that are formed from a wide bandgap material system significantly improves upon each of these limitations. With regard to switching frequency, minority carrier devices require the removal of residual carriers during each commutation, or switching event. Removal of these residual carriers takes time, which injects a delay in switching and translates into relatively lower switching frequencies. Majority carrier devices do not suffer from this limitation, as there are generally no residual carriers to remove during commutation. In addition to relatively higher switching frequencies being possible, the lack of residual carriers also translates to more efficient switching, and thus, much lower switching and lower overall power losses. Further, the switching losses for majority carrier-based modules generally do not vary with temperature, unlike the switching losses for minority carrier-based modules.

A six-pack module that uses majority carrier transistors and diodes also allows for hard-switching as opposed to the soft-switching, which is required for modules employing minority carrier transistors and diodes. Hard switching refers to the case where devices are allowed to turn on or off when there is an appreciable amount of voltage and current present during the commutation. Soft switching refers to the case where there is little or no voltage and current present during commutation. To ensure that soft switching occurs, additional circuitry is generally required. Thus, a six-pack module that employs majority carrier transistors and diodes can handle hard switching without requiring additional circuitry required by a module that employs minority carrier transistors and diodes.

Accordingly, a first embodiment of the disclosure provides for a six-pack power module, such as power module PM1, or other type of power module that employs majority carrier transistors and diodes. Majority carrier transistors generally include field effect transistors (FETs), such as MOSFETs, HEMTs, JFETs, and the like, but will not include thyristors, bipolar transistors, and IGBTs. Majority carrier diodes generally include Schottky diodes, such as a junction barrier Shottky (JBS) diode. For the description herein and the claims that follow, reference to a particular "transistor" or "diode" may refer to a singular transistor or diode or an array of effectively parallel transistors or diodes, as illustrated in Figure 4.

In a second embodiment, the transistors and diodes for the power module are formed from a wide bandgap material system, such as SiC. For the purposes herein, a wide bandgap material system is one that provides bandgaps greater than or equal to 3.0 electron-volts (eV). SiC has a bandgap of approximately 3.3 eV. For reference, Si has a bandgap of approximately 1.1 eV, and GaAs has a bandgap of approximately 1.4 eV, wherein both Si and GaAs are not considered wide bandgap material systems for the purposes of this disclosure. Notably, the transistors and diodes may be formed from different material systems. For example, the transistors may be HEMTs and the diodes may be SiC-based JBS diodes.

In a third embodiment, the transistors and diodes for the power module are majority carrier devices and are both formed from a wide bandgap material system. A particularly effective combination has proven to be a SiC MOSFET with a SiC Schottky diode, such as a JBS diode. As such, the power module PM1 of Figure 7 would have SiC MOSFETS for MOSFETs Q5-Q10 and SiC JBS diodes for diodes D5-D10, wherein each of these devices may be implemented in an array as opposed to in a single device. The MOSFETs may be replaced with other types of FETs and traditional Schottky (non JBS) diodes may be used in place of the JBS diodes.

Compared with a state-of-the-art six-pack module that employs Si IGBTs and PiN diodes and is rated at 1200V and 50A, a six-pack power module PM1 that employs a SiC MOSFETs and JBS diodes offers significantly lower switching losses and can operate at much higher switching frequencies. For a first example, a six-pack module rated at 1200V and 50A can have switching losses of less than 10 milli-Joules (mJ) for any temperature between -40C and 150C, while maintaining a low on-state voltage drop.

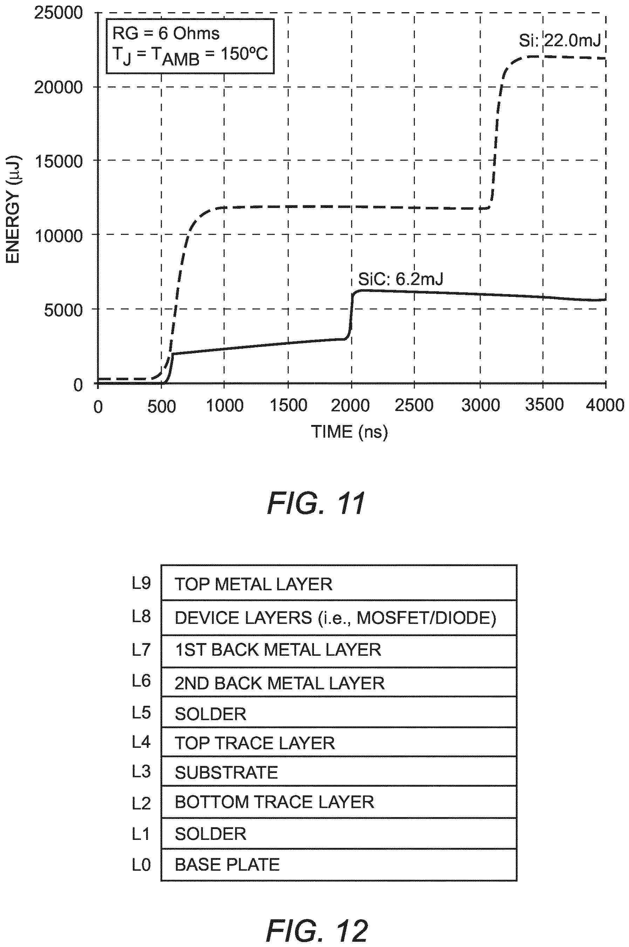

Figure 11 provides a graph that illustrates a 72% reduction in switching losses when transitioning from a power module that employs Si IGBTs and PiN diodes to one that employs SiC MOSFETs and JBS diodes when blocking 800V and conducting 100A. From the graph, the Si-based power module has switching losses of 22.0 mJ while the SiC-based power module has switching losses of only 6.2 milli-Joules. Further, the use of SiC MOSFETs and JBS diodes allows for much higher switching frequencies than a power module employing Si IGBTs and PiN diodes.

The following compares a state-of-the-art 1200V/50A Si-based six-pack module that employs IGBT and PiN diodes to a 1200V/50A SiC-based six-pack module to demonstrate tremendous increase in switching frequency that the SiC-based module exhibits over the state-of-the-art Si-based module.

For this example, assume the modules are used in a three-phase inverter circuit topology. Both modules (the Si-based IGBT/PiN diode and the SiC-based MOSFET/JBS diode) were cooled using state-of-the-art liquid cooling methods. The key characteristics of the three-phase inverter circuit used for this study are defined in Table A.

| **Table A: Nominal Operating Conditions** | | |
|---|---|---|
| Output Frequency, fout | 60.0 | Hz |
| Bus Voltage, Vbus | 675 | Volts |
| Rated Output Voltage, VLL | 400 | Vrms |
| Rated Current, Iphase | 33.0 | Arms |
| Power Factor, PF | 1 | |
| Rated Power, Pw | 22.9 | kW |

A summary of the simulation results is shown in Table B below. The analysis shows that for this application, a state of the art 1200V/50A Si-based module can only reach a maximum switching frequency of 30 kHz before it reaches its maximum junction temperature of 150 C. The SiC-based module, however, it is able to reach 390 kHz (about 13 times higher) for a similar junction temperature.

| **Table B** | **Si-based Power Module** | | **SiC-based Power Module** |
|---|---|---|---|
| ***Module Rated Current (A)*** | 50 | | 50 |
| ***Switching Frequency (kHz)*** | 30 | | 390 |
| ***Transistor Switching Loss (W)*** | 92.5 | | 123.1 |
| ***Diode Switching Loss (W)*** | 52.2 | | 0.0 |
| ***Transistor Conduction Loss (W)*** | 25.1 | | 24.3 |
| ***Diode Conduction Loss (W)*** | 2.3 | | 0.5 |
| ***Junction Temp (@Fluid*** = ***60 °C)*** | 149.0 | | 148.8 |
| ***Total System Loss (W)*** | 1032.8 | | 887.3 |

In practice, the SiC-based modules can achieve switching frequencies before reaching maximum junction temperatures (150 C) greater than 50kHz, 75kHz, 125kHz, and even 200kHz with blocking voltage ratings above 550V and forward current ratings above 45 amps when operating at voltage and current levels of at least half of their rated levels. For example, a 1200V/50A SiC-based module can operate at switching frequencies greater than 50kHz, 75kHz, 125kHz, and even 200kHz.

The concepts of the present disclosure also allow greater power densities than possible with Si-based power modules. Power density (PD) is determined herein by the following equation: PD = ((V_{b} * I_{c}) / Aₕ) / SM#, wherein V_{b} is the rated reverse blocking voltage, I_{c} is the rated conducting current, Aₕ is the total interior area of the housing, and SM# is the number of switch modules SMx provided by the power module. For example, a 1200V, 50A power module PM1 in a six-pack configuration and mounted in housing having an interior area of 29.63 cm² would result in a PD of 337.7 watts/cm², where V_{b} is 1200V, I_{c} is 50A, An is 29.64 cm², and SM# is 6. While Si-based power modules are approaching their power density limits at these ratings and in this size of housing, the power modules of the present disclosure are capable of achieving much greater power densities. For example, the power modules of the present disclosure are capable of achieving power densities equal to and greater than 400 watts/cm², 425 watts/cm², 450 watts/cm², 475 watts/cm², and 500 watts/cm².

With reference to Figure 12, an exemplary internal structure is provided for the power module PM1. This structure will reside within the interior opening of the housings H1 or H2. Starting at the bottom, a base plate L0 formed from aluminum silicon carbide (AlSiC), acts as a foundation on which a substrate L3 is attached. The substrate L3 is formed from silicon nitride (SiN), and has metal traces formed on the bottom and top thereof from respective bottom and top trace layers L2 and L4. The bottom and top trace layers L2 and L4 may be copper, or the like. The substrate L3 may be attached to the base plate L0 by soldering the bottom traces that are formed from the bottom trace layer L2 to the base plate L0. The solder is represented by the solder layer L1.

The transistors and diodes for the power module PM1 are formed on a die that is represented by the device layers L8. The device layers L8 may have one or more metal layers on the top and bottom from which traces and contacts are formed. In the illustrated example, the bottom traces and contacts are formed from a multi-layer back metal structure including first and second back metal layers L7 and L6. The second back metal layer L6 may be silver (Ag), or the like. The first back metal layer L7 may be nickel (Ni), or the like. The top traces and contacts may be formed from aluminum (Al), and the like and are represented by the top metal layer L9. The device layers L8 may be soldered to the substrate L3 by soldering portions of the second back metal layer L6 to the top trace layer L4. The solder is represented by the solder layer L5.

The thickness of the substrate L3 may be selected based on the targeted isolation voltage. With the increased power handling capabilities of the power modules of the present disclosure, either power modules of the same size can handler greater power, or the size of the power modules may be reduced while handling the same power.

The following description outlines several transistor configurations that can be used in the power modules described above as MOSFETs Q1_{N}-Q10_{N} or alternatives thereto. Other transistor configurations may be employed. Some embodiments of the disclosure provide silicon carbide (SiC) insulated gate devices that are suitable for high power and/or high temperature applications.

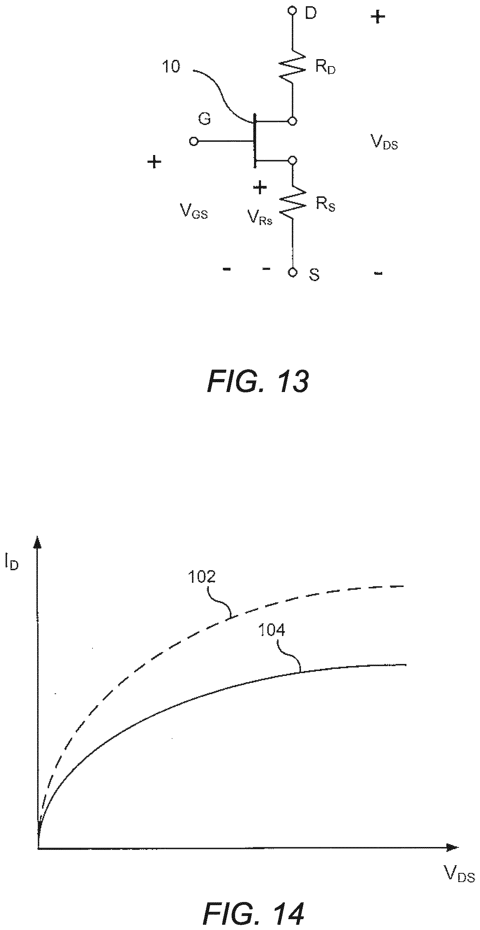

Figure 13 is a circuit diagram of a metal oxide semiconductor field effect transistor (MOSFET) device 10. As shown therein, a MOSFET device generally includes three terminals, namely, a drain terminal (D), a source terminal (S) and a gate terminal (G). The gate-to-source voltage of the device is denoted V_{GS}, while the drain-to-source voltage of the device is denoted V_{DS}. The device has a built in source resistance Rs and a built-in drain resistance R_{D} based on the physical characteristics of the device. The voltage over the built-in source resistance Rs is denoted V_{Rs}.

In a MOSFET device, current passing through a channel of the device from the drain to the source is regulated by applying a voltage to the gate. The gate is insulated from the channel by a gate insulator, such as silicon dioxide. As the voltage on the gate terminal is increased, current passing through the device may increase.

Figure 14 is a graph illustrating hypothetical (curve 102) and actual (104) on-state current-voltage characteristics for a MOSFET device for a given gate-to-source voltage (V_{GS}). As shown in Figure 14, for a given gate voltage, the current through the device (I_{D}) increases as the voltage between the drain and source (V_{DS}) increases, up to a saturation point. In actual devices, the actual saturation current of a transistor is typically less than the ideal saturation current. Part of the reason for this relates to the source resistance of the device.

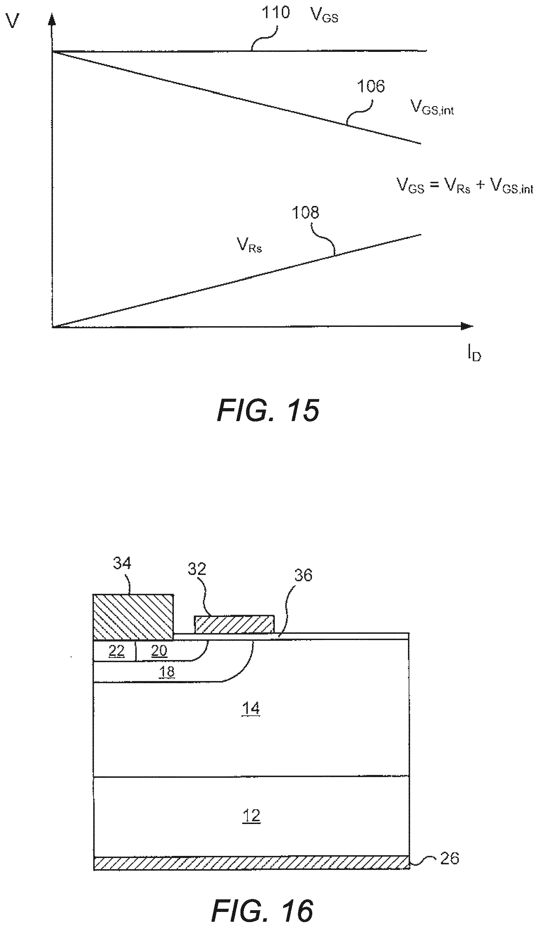

In particular, as the drain current I_{D} passing through the device increases, the amount of voltage dropped over the source resistance Rs increases in direct proportion. Figure 15 is a graph illustrating the effect of source resistance on gate voltage. In Figure 15, the voltage from the gate terminal to the source terminal is denoted V_{GS}. A portion of the gate voltage V_{GS} applied to the device across the gate and source terminals is dropped over the internal source resistance Rs of the device. That portion of the gate voltage is denoted V_{Rs} in Figure 15. The remainder of the gate-to-source voltage appears as a voltage across the gate insulator, denoted V_{GS,int} in Figure 15. Thus, V_{GS} is equal to the sum of V_{Rs} and V_{GS,int}.

As shown in Figure 15, the gate-to-source voltage may remain constant as the drain current increases. However, the portion of the gate voltage V_{GS} that is dropped over the internal source resistance of the device, V_{Rs}, increases as the drain current I_{D} increases, while the portion of the gate-to-source voltage that appears as a voltage across the gate insulator, V_{GS, int}, decreases as the drain current I_{D} increases.

Thus, as the drain current increases the portion of the gate voltage that is being used to maintain the channel decreases, which may cause the device to go into saturation at a lower level of drain-to-source voltage. Accordingly, a high source resistance can adversely affect the operation of a MOSFET or other insulated gate controlled device.

A unit cell 10 of a MOSFET is shown in Figure 16. The device 10 of Figure 16 includes an n- drift epitaxial layer 14 on an n-type, 8° off-axis 4H-SiC substrate 12. The n- drift layer 14 may have a thickness of about 100 µm to about 120 µm, and may be doped with n-type dopants at a doping concentration of about 2 ×10¹⁴ cm⁻³ to about 6×10¹⁴ cm⁻³ for a blocking capability of about 10 kV. Other doping concentrations/voltage blocking ranges are also possible. For a 1200V MOSFET device, the substrate may be 4° off-axis 4H-SiC and the drift layer may have a thickness of about 10 µm and may be doped with n-type dopants at a doping concentration of about 6 ×10¹⁵ cm⁻³.

The structure further includes a p+ well region 18 and an n+ source region 20 that may be formed by selective implantation of, for example, aluminum and nitrogen, respectively. The junction depth of the p+ well region 18 may be about 0.5 µm, although other depths are possible. The structure 10 further includes a p+ contact region 22 that extends from a surface of the drift layer 14 into the p+ well region 18. A junction termination (not shown) may be provided around the device periphery.

All of the implanted dopants may be activated by annealing the structure at a temperature of about 1600°C with a silicon over pressure and/or covered by an encapsulation layer such as a graphite film. A high temperature anneal may damage the surface of the silicon carbide epitaxy without these conditions. The silicon overpressure may be provided by the presence of silane, or the close proximity of silicon carbide coated objects that provide a certain amount of silicon overpressure. Alternatively or in combination with silicon overpressure, a graphite coating may be formed on the surface of the device. Prior to annealing the device to activate the implanted ions, a graphite coating may be applied to the top/front side of the structure in order to protect the surface of the structure during the anneal. The graphite coating may be applied by a conventional resist coating method and may have a thickness of about 1 µm. The graphite coating may be heated to form a crystalline coating on the drift layer 14. The implanted ions may be activated by a thermal anneal that may be performed, for example, in an inert gas at a temperature of about 1600 °C or greater. In particular the thermal anneal may be performed at a temperature of about 1600 °C in argon for 5 minutes. The graphite coating may help to protect the surface of the drift layer 14 during the high temperature anneal.

The graphite coating may then be removed, for example, by ashing and thermal oxidation.

After implant annealing, a field oxide of silicon dioxide (not shown) having a thickness of about 1 µm may be deposited and patterned to expose the active region of the device.

A gate oxide layer 36 may be formed by a gate oxidation process, with a final gate oxide thickness of 400-600Å.

In particular, the gate oxide may be grown by a dry-wet oxidation process that includes a growth of bulk oxide in dry O₂ followed by an anneal of the bulk oxide in wet O₂ as described, for example, in U.S. Patent No. 5,972,801. As used herein, anneal of oxide in wet O₂ refers to anneal of an oxide in an ambient containing both O₂ and vaporized H₂O. An anneal may be performed in between the dry oxide growth and the wet oxide growth. The dry O₂ oxide growth may be performed, for example, in a quartz tube at a temperature of up to about 1200 °C in dry O₂ for a time of at least about 2.5 hours. Dry oxide growth is performed to grow the bulk oxide layer to a desired thickness. The temperature of the dry oxide growth may affect the oxide growth rate. For example, higher process temperatures may produce higher oxide growth rates. The maximum growth temperature may be dependent on the system used.

The dry O₂ oxide growth may be performed at a temperature of about 1175 °C in dry O₂ for about 3.5 hours. The resulting oxide layer may be annealed at a temperature of up to about 1200 °C in an inert atmosphere. In particular, the resulting oxide layer may be annealed at a temperature of about 1175 °C in Ar for about 1 hour. The wet O₂ oxide anneal may be performed at a temperature of about 950°C or less for a time of at least about 1 hour. The temperature of the wet O₂ anneal may be limited to discourage further thermal oxide growth at the SiC/SiO₂ interface, which may introduce additional interface states. In particular, the wet O₂ anneal may be performed in wet O₂ at a temperature of about 950°C for about 3 hours. The resulting gate oxide layer may have a thickness of about 500 Å.

The dry O₂ oxide growth may be performed at a temperature of about 1175 °C in dry O₂ for about 4 hours. The resulting oxide layer may be annealed at a temperature of up to about 1175 °C in an inert atmosphere. In particular, the resulting oxide layer may be annealed at a temperature of about 1175 °C in Ar for about a time duration ranging from 30 min to 2 hours. Then the oxide layer receives an anneal in NO ambient at a temperature ranging from 1175 °C to 1300C, for a duration ranging from 30 minutes to 3 hours. The resulting gate oxide layer may have a thickness of about 500 Å.

After formation of the gate oxide 36, a polysilicon gate 32 may be deposited and doped, for example, with boron followed by a metallization process to reduce the gate resistance. Al/Ni contacts may be deposited as the p-type ohmic source contact metal 28, and Ni as the n-type drain contact metal 26. All contacts may be sintered in a Rapid Thermal Annealer (RTA), and thick Ti/Au layers may be used for pad metals.

Referring to Figure 16, the source resistance of a MOSFET device has two primary components, namely, the contact resistance Rc between the source ohmic contact 34 and the source region 20, and the sheet resistance Rₛₕₑₑₜ in the source region 20 between the source ohmic contact 34 and the channel. Thus, R_{S} = R_{C} + Rₛₕₑₑₜ. In a conventional silicon-based MOSFET device, the sheet resistance Rₛₕₑₑₜ is the dominant factor in determining the source resistance, because it is possible to form very low resistivity ohmic contacts to silicon and other narrow-bandgap semiconductors. However, in wide bandgap semiconductors (i.e., semiconductors having a bandgap greater than about 2.0 V), including compound semiconductor materials, such as silicon carbide and gallium nitride, diamond, and ZnO, the contact resistance Rc may be the dominant contributor to the source resistance. In particular, it is difficult to form very low resistivity ohmic contacts to silicon carbide and other wide bandgap materials because of the high energy barrier associated with such materials.

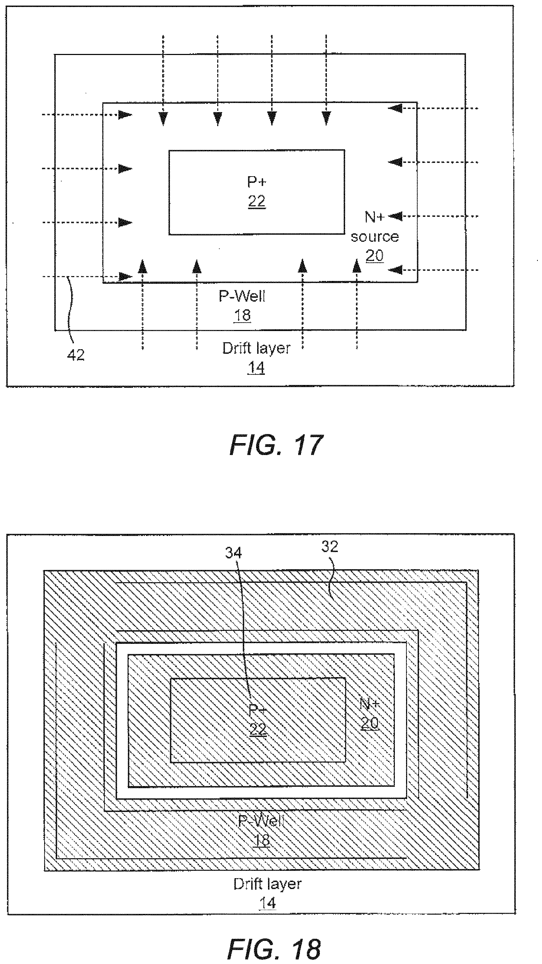

Figures 17 and 18 are plan views illustrating layouts of conventional power MOSFET devices. In a conventional power MOSFET device, the layout is designed to reduce or minimize sheet resistance under the assumption that contact resistance is less important than sheet resistance. Thus, referring to Figure 17, a conventional power MOSFET device typically includes a p-well 18 formed in a drift layer 14, an n+ source region 20 in the p-well 18, and a p+ contact region 22 in the n+ source region 20. Referring to Figure 18, a source contact 34 is formed on the n+ source region 20 and the p+ contact region 22. A gate 32 is formed over the p-well 18 and overlaps the periphery of the n+ source region 20 and adjacent portions of the drift layer 14. Current flow from the drain to the source is indicated by the arrows 42 in Figure 17.

As noted above, in a wide bandgap semiconductor material system, the source resistance may be more affected by the contact resistance of the source ohmic contact than by the sheet resistance of the source layer. Accordingly, to decrease the source resistance of a wide bandgap power semiconductor device, it may be desirable to decrease the contact resistance of the source ohmic contact. In general, contact resistance can be decreased by increasing the minimum dimension of the contact, which is the smallest dimension of the contact in any direction. However, simply increasing the minimum dimension of the source ohmic contact of an electronic device can undesirably increase the cell to cell spacing, or pitch, of the device. The pitch of a MOSFET device may be proportional to the width of the p-well region of the device. Increasing the pitch of the device reduces the density of the devices that can be formed on a single substrate, reducing the devices yielded and increasing manufacturing costs.

According to some examples, an insulated gate device layout is provided that increases the minimum dimension of the source ohmic contact without increasing the pitch of the device and/or the width of the p-well region of the device. A device layout according to some examples may increase the sheet resistance of the device. Such an effect may be highly undesirable in a device based on a narrow bandgap semiconductor material. However, since sheet resistance is not the dominant factor in determining source resistance of a wide bandgap device, such a tradeoff may be acceptable for wide bandgap devices. In devices according to some examples, a ratio of the source sheet resistance to the source contact resistance may be greater than 0.75 (i.e. Rₛₕₑₑₜ/R_{C} > 0.75). In some examples, the device may have a source contact resistance that is less than the source sheet resistance. That is, in some examples, the ratio of the source sheet resistance to the source contact resistance may be greater than 1 (i.e. Rₛₕₑₑₜ/R_{C} > 1), and in further examples, the ratio of the source sheet resistance to the source contact resistance may be greater than 5.

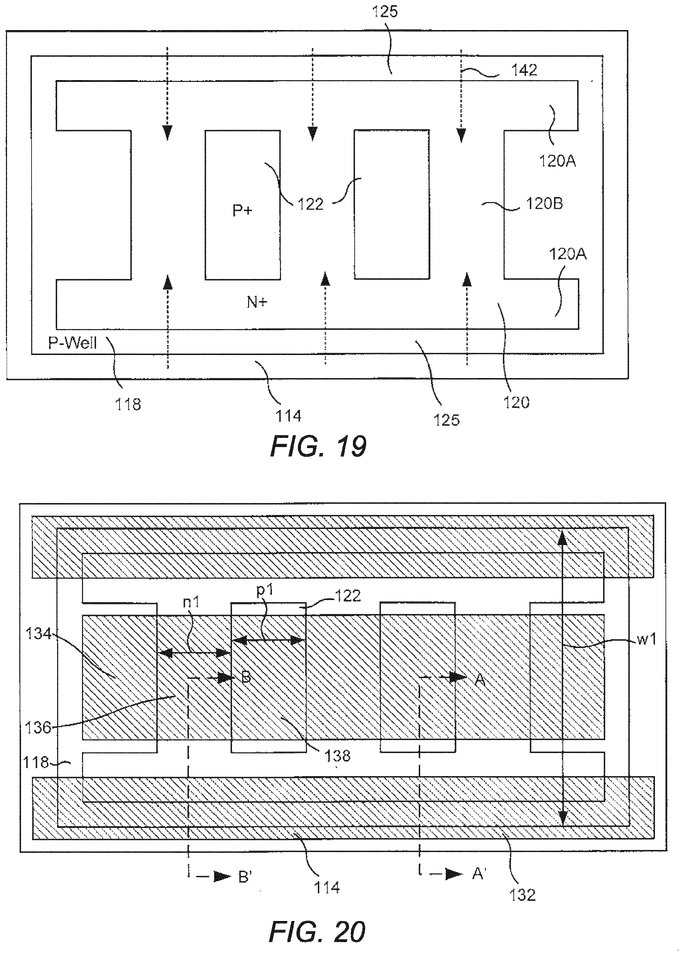

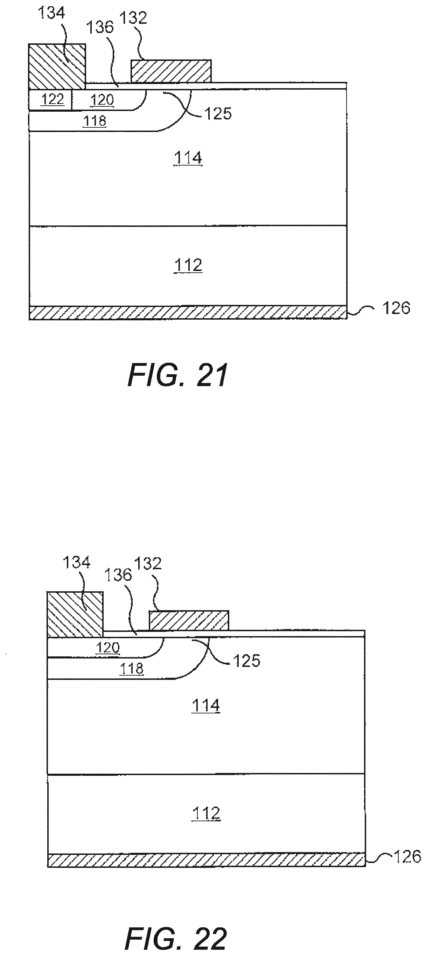

Figures 19 and 20 are plan views illustrating layouts of MOSFET device cells 100, and Figures 21 and 22 are partial cross sectional illustrations of a cell of a MOSFET device. In particular, Figure 21 is a cross section taken along line A-A' of Figure 20, while Figure 22 is a cross section taken along line B-B' of Figure 20.

The device 100 shown in Figures 19-22 includes an n- drift epitaxial layer 114 on an n-type, 8° off-axis 4H-SiC substrate 112. The n- drift layer 114 may have a thickness of about 100 µm to about 120 µm, and may be doped with n-type dopants at a doping concentration of about 2 ×10¹⁴ cm⁻³ to about 6×10¹⁴ cm⁻³ for a blocking capability of about 10 kV. For a 1200V MOSFET device, the substrate may be 4° off-axis 4H-SiC and the drift layer may have a thickness of about 10 µm and may be doped with n-type dopants at a doping concentration of about 6 ×10¹⁵ cm⁻³.

The structure further includes a p+ well region 118 and an n+ source region 120 that may be formed by selective implantation of, for example, aluminum and nitrogen, respectively. The junction depth of the p+ well region 118 may be about 0.5 µm. The structure 100 further includes a plurality of p+ contact regions 122 that extend from a surface of the drift layer 114 into the p+ well region 118. A junction termination (not shown) may be provided around the device periphery.

Referring to Figure 19, the n+ source region 120 includes a pair of lateral source regions 120A that are parallel to opposing channel regions 125 in the p-well 118. A plurality of source contact regions 120B extend between the lateral source regions 120A, and the plurality of p+ contact regions 122 are provided between the source contact regions 120B.

Referring to Figure 20, gate contacts 132 are formed over the channel regions 125 and overlap the lateral source regions 120A. A source ohmic contact 134 is formed across the source contact regions 120B and the p+ contact regions 122. The source ohmic contact 134 overlaps the source contact regions 120B in a source contact region 136. The source ohmic contact 134 overlaps the p+ contact regions 122 in a body contact region 138.

The portion of the source contact regions 120B contacted by the source ohmic contact 134 may have a minimum dimension that is larger than the minimum dimension that can be obtained for a conventional layout such as the layout shown in Figures 17 and 18 for a similar pitch/p-well size. Accordingly, the source contact resistance may be reduced without substantially increasing the device pitch/p-well size. The "minimum dimension" of a feature refers to the smallest width of the feature in any cross section of the feature. For example, the minimum dimension p1 of the body contact region 138, the minimum dimension n1 of the n-type contact region 136 and the minimum dimension w1 of the p-well region 118 are shown in Figure 20.

In a device having a layout as shown in Figures 19 and 20, current flow to the source contact flows through the source contact regions 120B, as indicated by the arrows 142 in Figure 19. The source contact regions 120B may have an increased sheet resistance compared to the source region of a device having a conventional layout as shown in Figures 17 and 18. However, the increase in sheet resistance may be more than compensated by the decrease in contact resistance, thus providing an overall decrease in the source resistance of the device.

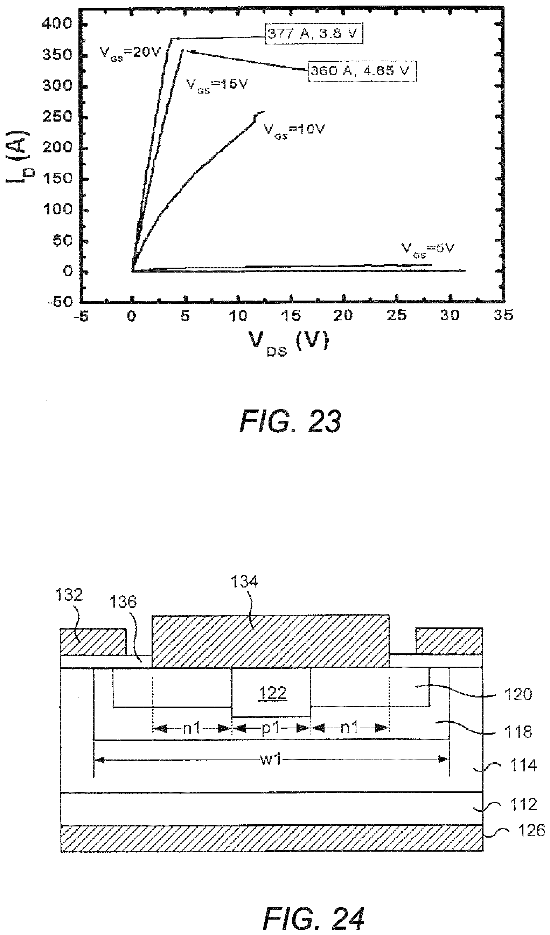

Figure 23 is a graph of on-state current-voltage characteristics for a 7 mm × 8 mm 1200 V silicon carbide MOSFET device. In the device characteristics illustrated in Figure 23, a drain current (I_{D}) of 377 A was measured at a forward voltage drain-to-source voltage (V_{DS}) of 3.8 V. The current density, normalized to the active area, was over 750 A/cm².

The on-resistance of a MOSFET device is affected by the drain resistance, the channel resistance and the source resistance of the device. Accordingly, reducing the source resistance of the device also reduces the on-resistance of the device.

A wide bandgap MOSFET device having a layout according to some examples may be capable of substantially increased saturation current due to the lower on-resistance of the device and the fact that increased current levels have less of a de-biasing effect on the gate. That is, because of the lower source resistance, less voltage will be developed over the source resistance as the drain current increases. Thus, more of the gate-to-source voltage is applied to the channel of the device.

Figure 24 is an idealized cross section of a device having a layout in accordance with some examples. In particular, Figure 24 illustrates some dimensions of a device having a layout in accordance with some examples. For example, as shown in Figure 24, the minimum dimension of the implanted cell area (i.e. the p-well 118) is denoted as width w1 in Figure 24. It will be appreciated, however, that the minimum dimension of the p-well 118 may occur in a dimension that is different from the plane of the device illustrated in Figure 24. For example, the minimum dimension of the p-well 118 may occur in a dimension that is perpendicular to the plane of the device illustrated in Figure 24.

The minimum dimension of the n-type contact area is denoted as width n1 in Figure 24, while the minimum dimension of the p-type contact area is denoted as width p1 in Figure 24. The n-type contact area may be defined as the area of overlap between the source ohmic contact 134 and the n+ source region 120, while the p-type contact area may be defined as the area of overlap between the source ohmic contact 134 and the p+ contact regions 122.

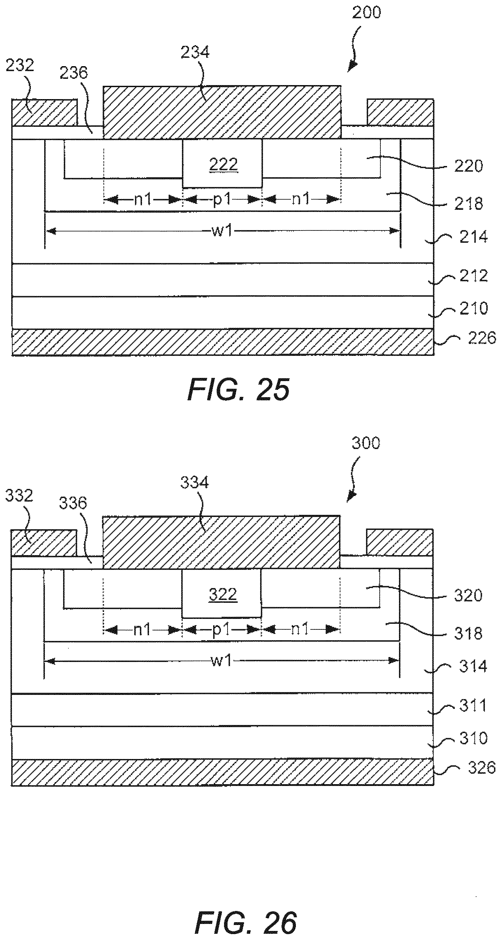

An insulated gate bipolar transistor (IGBT) device 200 is illustrated in Figure 25. As shown therein, the IGBT device includes an n- drift epitaxial layer 214 on a p-type epitaxial layer 212. The p-type epitaxial layer 212 is formed on a heavily doped p-type, 8° off-axis 4H-SiC substrate or layer 210. The n- drift layer 214 may have a thickness of about 100 µm to about 120 µm, and may be doped with p-type dopants at a doping concentration of about 2 ×10¹⁴ cm⁻³ to about 6×10¹⁴ cm⁻³ for a blocking capability of about 10 kV.

The IGBT structure 200 further includes a p+ well region 218 and an n+ source/emitter region 220 that may be formed by selective implantation of, for example, aluminum and nitrogen, respectively. The junction depth of the p+ well region 218 may be about 0.5 µm. The structure 200 further includes a plurality of p+ body contact regions 222 that extend from a surface of the drift layer 214 into the p+ well region 218. The conductivity types may be reversed in some examples.

A gate contact 232 is on a gate insulator 236, a source/emitter contact 234 is on the source contact regions 220 and the body contact regions 222. A collector contact 226 contacts the substrate 210.

A transistor device may have a ratio of n1 to w1 that is greater than 0.2. A transistor device may have a ratio of n1 to w1 that is greater than about 0.3. A transistor device may have a ratio of n1 to w1 that is in the range of about 0.2 to 1. A transistor device may have a ratio of n1 to w1 that is in the range of about 0.3 to 1. Transistor device may have a ratio of n1 to w1 that is greater than 0.5. For example, the minimum dimension n1 of the n-type contact area of a device having a layout according to some examples may be about 2 µm for a device having a minimum dimension of the implanted cell area of 6 µm.

A transistor device may have a ratio of p1 to w1 that is greater than 0.2. A transistor device may have a ratio of p1 to w1 that is greater than about 0.3. A transistor device may have a ratio of p1 to w1 that is greater than about 0.5. A transistor device may have a ratio of p1 to w1 that is in the range of about 0.2 to 0.5. A transistor device may have a ratio of p1 to w1 that is in the range of about 0.2 to 1.

Some embodiments provide transistor devices having increased current densities. Current density is defined as the total current divided by the area of the chip. For example, a wide bandgap transistor device according to some embodiments may be capable of current densities in excess of 200A/cm² and a blocking voltage of 1000 V or more. A wide bandgap transistor device according to further embodiments may be capable of a current of 100 A or greater at current densities in excess of 200A/cm², a forward voltage drop of less than 5 V and a blocking voltage of 1000 V or more. A wide bandgap transistor device according to still further embodiments may be capable of a current of 100 A or greater at current densities in excess of 300A/cm², a forward voltage drop of less than 5 V and a blocking voltage of 1000 V or more.

A semiconductor device according to some embodiments has a reverse blocking voltage in excess of 1000 volts and a current density greater than 200 amps per square centimeter at a current greater than 100 A.

A semiconductor device according to further embodiments has a reverse blocking voltage of 1000 volts or more and a forward current capability greater than 100 A at a forward voltage of 5 volts or less.

A metal-oxide semiconductor field effect transistor device according to some embodiments has a reverse blocking voltage of 1200 volts or more and a forward current capability greater than 100 A.

A metal-oxide semiconductor field effect transistor device according to some embodiments has a reverse blocking voltage of 1000 volts or more and a differential on-resistance less than 8 mOhms-cm².

A semiconductor device having a blocking voltage less than 1000 V and configured to pass forward current at a current density greater than 200 amps per square centimeter at a forward voltage drop of 5 V or less.

Some embodiments may enable wide bandgap transistor devices to achieve drain currents of 100 Amps or higher at a drain to source voltage that is less than 4 Volts in a device having a cell pitch of less than 20 µm. Some embodiments may enable wide bandgap transistor devices to achieve drain currents of 100 Amps or higher at a drain to source voltage that is less than 4 Volts in a device having a cell pitch of less than 10 µm. Some embodiments may enable wide bandgap transistor devices to achieve drain currents of 80 Amps or higher at a drain to source voltage that is less than 5 Volts in a device having a cell pitch of less than 10 µm.

An IGBT device according to some embodiments with a voltage blocking capability of 10 kV or greater may have a differential specific on-resistance of less than 14 mOhm-cm² with a forward voltage drop of 5.2 V or less at a current density of 100 A/cm².

A p-type insulated gate bipolar transistor (p-IGBT) device 300 according to some embodiments is illustrated in Figure 26. As shown therein, the IGBT device includes a p- drift epitaxial layer 314 on a p-type field stop buffer layer 311 formed on an n-type, 8° off-axis 4H-SiC substrate 310. The p- drift layer 314 may have a thickness of about 100 µm to about 200 µm, and may be doped with p-type dopants at a doping concentration of about 2 ×10¹⁴ cm⁻³ to about 6×10¹⁴ cm⁻³.

The p-IGBT structure 300 further includes an n+ well region 318 and a p+ source/emitter region 320 that may be formed by selective implantation of, for example, nitrogen and aluminum, respectively. The junction depth of the n+ well region 318 may be about 0.5 µm. The structure 300 further includes a plurality of n+ body contact regions 322 that extend from a surface of the drift layer 314 into the n+ well region 318.

A gate contact 332 is on a gate insulator 336, a source/emitter contact 334 is on the source contact regions 320 and the body contact regions 322. A collector contact 326 contacts the substrate 310.

A 4H-SiC p-IGBT as shown in Figure 26 was fabricated using a 2×10¹⁴ cm⁻³ doped, 140 µm thick p-type epilayer as the drift layer 314, and a 2 µm thick p-type Field-Stop buffer layer 311, with a doping concentration ranging from 1×10¹⁷ cm⁻³ to 5×10¹⁷ cm⁻³. A multi-zone JTE (15 zone) edge termination structure (not shown) was formed by nitrogen ion implantation. JTE terminations are described, for example, in U.S. Patent No. 6,002,159. MOS channels were formed on implanted n-wells 318. A 50 nm thick thermally grown oxide layer was used as the gate insulator 336.

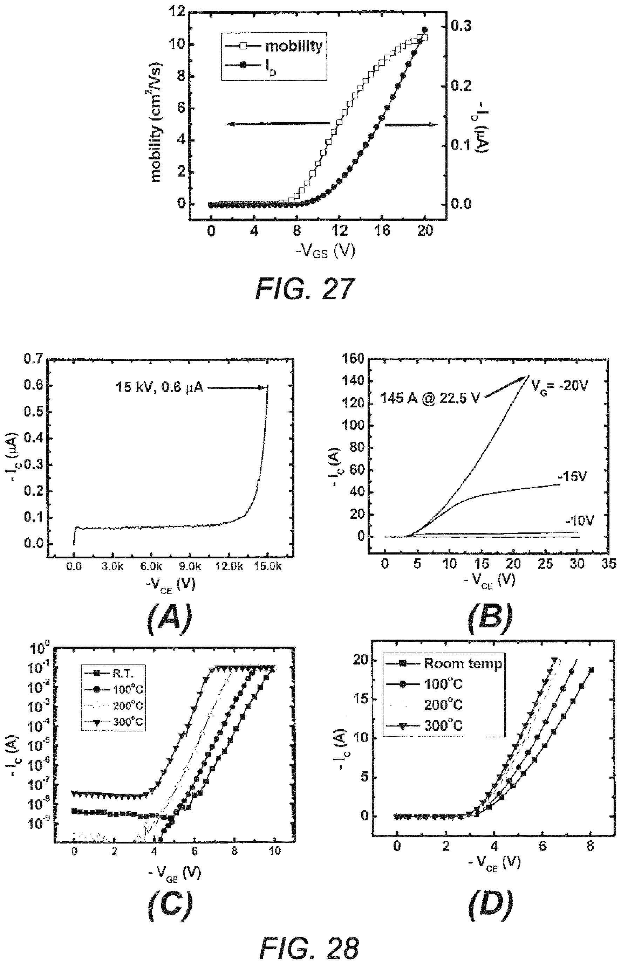

Figure 27 shows the I_{D}-V_{GS} characteristics of the p-IGBT device shown in Figure 26, with V_{DS} fixed at -50 mV. The I_{D}-V_{GS} characteristics were measured from a test MOSFET with a W/L of 200 µm / 200 µm, fabricated on the same wafer. A threshold voltage of -10 V, and a peak MOS channel mobility of 10 cm²/Vs were extracted from the I_{D}-V_{GS} characteristics.

Figure 28A shows the blocking characteristics (V_{GE} = 0 V) of a 6.7 mm × 6.7 mm 4H-SiC P-IGBT, with an active area of 0.16 cm² at room temperature. The measurement voltage was limited to -15 kV, due to the limitation of probing equipment. The device showed a leakage current of 0.6 µA, which corresponds to a leakage current density of 1.2 µA/cm² at a V_{CE} of -15 kV. This is the highest blocking voltage ever reported in SiC power switches. Figure 28B shows the pulsed on-state I-V characteristics of the p-IGBT, measured using a Tektronix 371 curve tracer. The device showed an on-state current of -145 A, which represents a current density of 906 A/cm², at a V_{CE} of - 22.5 V and a V_{GE} of -20 V. No evidence of parasitic thyristor latch-up was observed during this measurement. Figure 28C shows I_{C}-V_{GE} characteristics of the 4H-SiC P-IGBTs for temperatures ranging from room temperature to 300°C. V_{CE} was fixed at -10V for this measurement. The I-V characteristics shifted towards zero at elevated temperature. However, the device maintained normally-off properties throughout the temperature range. Figure 28D shows the on-state I-V characteristics as a function of temperature. V_{GE} was fixed at -20 V for this measurement. A monotonic decrease in forward voltage drop with increasing temperature was observed. This is believed due to the increase in minority carrier (electron) diffusion length, caused by increased carrier lifetime at elevated temperatures.

Accordingly, a p-IGBT according to some embodiments may have a reverse blocking voltage that is greater than about 10 kV, and in some cases greater than about 13 kV, and that has a forward current capability greater than 5 Amps.

It will be appreciated that although some examples have been described in connection with silicon carbide IGBT and MOSFET devices having n-type drift layers, the present disclosure is not limited thereto, and may be embodied in devices having p-type substrates and/or drift layers. Furthermore, the disclosure may be used in many different types of devices, including but not limited to insulated gate bipolar transistors (IGBTs), MOS controlled thyristors (MCTs), insulated gate commutated thyristors (IGCTs), junction field effect transistors (JFETs), high electron mobility transistors (HEMTs), etc.

In the drawings and specification, there have been disclosed typical embodiments of the disclosure and, although specific terms are employed, they are used in a generic and descriptive sense only and not for purposes of limitation, the scope of the disclosure being set forth in the following claims.

## Claims

1. A power module comprising:
a housing (H1, H2) having an opening;
a baseplate (L0) within the opening and comprising aluminum silicon carbide;
a power substrate (L3) on the baseplate, the power substrate comprising silicon nitride;
a bottom metal trace layer (L2) that is arranged between the power substrate and the baseplate;
a top metal trace layer (L4) that is arranged on an opposite side of the power substrate from the bottom metal trace layer (L2); and **characterized by**:
six switch modules (SM5-SM10) mounted on the top metal trace layer (L2) of the power substrate, each switch module comprising a silicon carbide transistor (Q5-Q10) coupled in anti-parallel with a silicon carbide diode, and a plurality of pins (13P-28P) is connected to one or more terminals of the silicon carbide transistor.

2. The power module of claim 1 wherein the power module has a power density of up to 500 watts/cm².

3. The power module of claim 1 wherein each switch module is configured to provide a blocking voltage greater than 1000 V and a forward current greater than 50 A.

4. The power module of claim 3 wherein each switch module is configured to provide switching losses less than 10 milli-Joules.

5. The power module of claim 4 wherein each switch module is capable of switching speeds of greater than 125 kHz.

6. The power module of claim 1 wherein the top metal trace layer (L4) is a first copper layer on a top side of the power substrate, and the bottom metal trace layer (L2) comprises a second copper layer.

7. The power module of claim 1 wherein the baseplate comprises a mounting structure (HS1) that is affixed to the housing, the power substrate comprises a first printed circuit board (PCB1), and the power module further comprises:
an additional power substrate comprising a second printed circuit board (PCB2) on the baseplate, the additional power substrate comprising silicon nitride.

8. The power module of claim 7 wherein the six switch modules are coupled together to facilitate switching power to a load (M1).

9. The power module of claim 1 wherein the six modules (SM5-SM10) provide a full-bridge power converter topology.

10. The power module of claim 1 wherein the diode is an internal body diode of the silicon carbide transistor.

11. The power module of claim 10 wherein the silicon carbide transistor is a metal-oxide-semiconductor field-effect transistor, MOSFET.

## Patentansprüche

1. Leistungsmodul, umfassend:
ein Gehäuse (H1, H2) mit einer Öffnung;
eine Grundplatte (L0) innerhalb der Öffnung, die Aluminium-Siliziumkarbid enthält;
ein Leistungssubstrat (L3) auf der Grundplatte, wobei das Leistungssubstrat Siliziumnitrid enthält;
eine untere metallische Leiterbahnschicht (L2), die zwischen dem Leistungssubstrat und der Grundplatte angeordnet ist;
eine obere metallische Leiterbahnschicht (L4), die auf einer der unteren metallischen Leiterbahnschicht (L2) gegenüberliegenden Seite des Leistungssubstrats angeordnet ist; und **gekennzeichnet durch**:
sechs Schaltmodule (SM5-SM 10), die auf der oberen metallischen Leiterbahnschicht (L2) des Leistungssubstrats angebracht sind, wobei jedes Schaltmodul einen Siliziumkarbid-Transistor (Q5-Q 10) umfasst, der antiparallel mit einer Siliziumkarbid-Diode gekoppelt ist, und eine Mehrzahl von Stiften (13P-28P) mit einem oder mehreren Anschlüssen des Siliziumkarbid-Transistors verbunden ist.

2. Leistungsmodul nach Anspruch 1, wobei das Leistungsmodul eine Leistungsdichte von bis zu 500 Watt/cm² aufweist.

3. Leistungsmodul nach Anspruch 1, bei dem jedes Schaltmodul konfiguriert ist, um eine Sperrspannung von mehr als 1000 V und einen Durchlassstrom von mehr als 50 A zu liefern.

4. Leistungsmodul nach Anspruch 3, bei dem jedes Schaltmodul konfiguriert ist, um Schaltverluste von weniger als 10 Millijoule zu liefern.

5. Leistungsmodul nach Anspruch 4, bei dem jedes Schaltmodul in der Lage ist, Schaltgeschwindigkeiten von mehr als 125 kHz zu erreichen.

6. Leistungsmodul nach Anspruch 1, bei dem die obere metallische Leiterbahnschicht (L4) eine erste Kupferschicht auf einer Oberseite des Leistungssubstrats ist und die untere metallische Leiterbahnschicht (L2) eine zweite Kupferschicht umfasst.

7. Leistungsmodul nach Anspruch 1, bei dem die Grundplatte eine Montagestruktur (HS1) umfasst, die an dem Gehäuse befestigt ist, das Leistungssubstrat eine erste gedruckte Leiterplatte (PCB1) umfasst, und das Leistungsmodul ferner umfasst:
ein zusätzliches Leistungssubstrat, das eine zweite gedruckte Leiterplatte (PCB2) auf der Grundplatte umfasst, wobei das zusätzliche Leistungssubstrat Siliziumnitrid enthält.

8. Leistungsmodul nach Anspruch 7, bei dem die sechs Schaltmodule miteinander gekoppelt sind, um das Schalten von Strom zu einer Last (M1) zu erleichtern.

9. Leistungsmodul nach Anspruch 1, bei dem die sechs Module (SM5-SM10) eine Vollbrücken-Stromwandlertopologie bilden.

10. Leistungsmodul nach Anspruch 1, bei dem die Diode eine körperinterne Diode des Siliziumkarbid-Transistors ist.

11. Leistungsmodul nach Anspruch 10, bei dem der Siliziumkarbid-Transistor ein Metalloxid-Halbleiter-Feldeffekttransistor, MOSFET, ist.

## Revendications

1. Module d'alimentation, comprenant :
un boîtier (H1, H2) présentant une ouverture ;
une plaque de base (L0) à l'intérieur de l'ouverture et comprenant du carbure de silicium et d'aluminium ;
un substrat d'alimentation (L3) sur la plaque de base, le substrat d'alimentation comprenant du nitrure de silicium ;
une couche de trace métallique inférieure (L2) qui est agencée entre le substrat d'alimentation et la plaque de base ;
une couche de trace métallique supérieure (L4) qui est disposée sur un côté opposé du substrat d'alimentation par rapport à la couche de trace métallique inférieure (L2) ; et **caractérisé par** :
six modules de commutation (SM5-SM10) montés sur la couche de trace métallique supérieure (L2) du substrat d'alimentation, chaque module de commutation comprenant un transistor en carbure de silicium (Q5-Q10) couplé en antiparallèle avec une diode en carbure de silicium, et une pluralité de broches (13P-28P) est connectée à une ou plusieurs bornes du transistor en carbure de silicium.

2. Module d'alimentation selon la revendication 1, dans lequel le module de puissance présente une densité de puissance allant jusqu'à 500 watts/cm².

3. Module de puissance selon la revendication 1, dans lequel chaque module de commutation est configuré pour fournir une tension de blocage supérieure à 1 000 V et un courant direct supérieur à 50 A.

4. Module d'alimentation selon la revendication 3, dans lequel chaque module de commutation est configuré pour fournir des pertes de commutation inférieures à 10 milli-Joules.

5. Module d'alimentation selon la revendication 4, dans lequel chaque module de commutation est capable de commuter des vitesses supérieures à 125 kHz.

6. Module d'alimentation selon la revendication 1, dans lequel la couche de trace métallique supérieure (L4) est une première couche de cuivre sur un côté supérieur du substrat d'alimentation, et la couche de trace métallique inférieure (L2) comprend une seconde couche de cuivre.

7. Module d'alimentation selon la revendication 1, dans lequel la plaque de base comprend une structure de montage (HS1) qui est fixée au boîtier, le substrat d'alimentation comprend une première carte de circuit imprimé (PCB1), et le module d'alimentation comprend en outre :
un substrat d'alimentation supplémentaire comprenant une seconde carte de circuit imprimé (PCB2) sur la plaque de base, le substrat d'alimentation supplémentaire comprenant du nitrure de silicium.

8. Module d'alimentation selon la revendication 7, dans lequel les six modules de commutation sont couplés ensemble pour faciliter la commutation de l'alimentation vers une charge (M1).

9. Module d'alimentation selon la revendication 1, dans lequel les six modules (SM5-SM10) fournissent une topologie de convertisseur d'alimentation en pont complet.

10. Module d'alimentation selon la revendication 1, dans lequel la diode est une diode de corps interne du transistor en carbure de silicium.

11. Module d'alimentation selon la revendication 10, dans lequel le transistor en carbure de silicium est un transistor à effet de champ métal-oxyde-semiconducteur, MOSFET.
